(19) Europäisches Patentamt
European Patent Office
Office européen des brevets

(11) **EP 4 696 821 A1**

(12) **EUROPEAN PATENT APPLICATION**
published in accordance with Art. 153(4) EPC

(43) Date of publication:
**18.02.2026 Bulletin 2026/08**

(21) Application number: **24788802.7**

(22) Date of filing: **11.04.2024**

(51) International Patent Classification (IPC):
$C30B\ 29/32^{(2006.01)}$    $C04B\ 35/468^{(2006.01)}$
$H10N\ 30/20^{(2023.01)}$    $H10N\ 30/30^{(2023.01)}$
$H10N\ 30/057^{(2023.01)}$    $H10N\ 30/077^{(2023.01)}$
$H10N\ 30/079^{(2023.01)}$    $H10N\ 30/88^{(2023.01)}$
$H10N\ 30/097^{(2023.01)}$    $H10N\ 30/853^{(2023.01)}$

(52) Cooperative Patent Classification (CPC):
C04B 35/468; C30B 29/32; H10N 30/057;
H10N 30/077; H10N 30/079; H10N 30/097;
H10N 30/20; H10N 30/30; H10N 30/853;
H10N 30/88

(86) International application number:
**PCT/JP2024/014677**

(87) International publication number:
**WO 2024/214780 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.04.2023 JP 2023066551
21.03.2024 JP 2024045263**

(71) Applicant: **Canon Kabushiki Kaisha
Tokyo, 146-8501 (JP)**

(72) Inventors:
• **FURUTA, Tatsuo**
 **Tokyo 146-8501 (JP)**
• **MATSUDA, Takanori**
 **Tokyo 146-8501 (JP)**
• **UEBAYASHI, Akira**
 **Tokyo 146-8501 (JP)**

(74) Representative: **TBK
Bavariaring 4-6
80336 München (DE)**

(54) **METHOD FOR PRODUCING SINGLE CRYSTAL, SINGLE CRYSTAL, PIEZOELECTRIC ELEMENT, ULTRASONIC MOTOR, OPTICAL DEVICE, VIBRATION DEVICE, DUST REMOVAL DEVICE, IMAGING DEVICE, ULTRASONIC PROBE, ULTRASONIC DIAGNOSTIC DEVICE, ULTRASONIC DIAGNOSTIC SYSTEM, AND ELECTRONIC DEVICE**

(57) Provided is a method of producing a single crystal by heating a matrix, the method including: a first temperature-increasing step of increasing a temperature of the integrated body from room temperature to a liquid-phase start temperature of the matrix; a second temperature-increasing step of increasing the temperature of the integrated body from the liquid-phase start temperature to a liquid-phase end temperature of the matrix; a heating step of heating the integrated body at the liquid-phase end temperature; and a step of obtaining a perovskite-type single crystal from the matrix after the heating. A rate of temperature increase in the second temperature-increasing step is lower than a rate of temperature increase in the first temperature-increasing step.

*FIG. 5*

EP 4 696 821 A1

**Description**

[Technical Field]

The present invention relates to a method of producing a single crystal, and a single crystal. The present invention also relates to a piezoelectric element, an ultrasonic motor, an optical apparatus, a vibration device, a dust removing device, an image pickup apparatus, an ultrasonic probe, an ultrasonic diagnostic apparatus, an ultrasonic diagnostic system, and an electronic apparatus, which use the single crystal.

[Background Art]

As a method for producing a single crystal such as barium titanate, Patent Literature 1 discloses a solid-state method in which a seed single crystal is joined to a matrix to be subjected to heat treatment to thereby cause abnormal grain growth in which only a single crystal grain grows, and the abnormal grain is cut out to obtain a single crystal.

Patent Literature 1 describes that barium titanate may be substituted with Zr or Mn, and describes a heat treatment temperature. However, Patent Literature 1 describes a rate of temperature increase or time for temperature increase in a temperature increase process during the heat treatment.

As a result of extensive studies by the inventors of the present invention, it has been found that material compositions for which it is difficult to cause abnormal grain growth are present, which allows a single crystal grain to grow, only by adjusting the heat treatment temperature.

Meanwhile, when a single crystal having piezoelectricity is used in a resonance device such as an ultrasonic motor, a large piezoelectric constant and a large mechanical quality factor representing the sharpness of resonance are required. When the piezoelectric constant and the mechanical quality factor are small, power required for operation becomes high. Accordingly, a single crystal having a large piezoelectric constant and a large mechanical quality factor is required.

[Citation List]

[Patent Literature]

PTL 1: Japanese Patent No. 3507821

[Summary of Invention]

[Technical Problem]

Only with adjustment of the heat treatment temperature as in the related art, material compositions for which it is difficult to cause abnormal grain growth are present, which allows only a single crystal grain to grow, resulting in a problem in that a single crystal having such a composition is not obtained.

The present invention has been made to solve such a problem, and is directed to provision of a method of producing a single crystal that can be applied to a wider range of material compositions to achieve a larger piezoelectric constant and a larger mechanical quality factor when the single crystal is used as a piezoelectric element.

Further, the present invention is also directed to provision of a single crystal that has a larger piezoelectric constant and a larger mechanical quality factor when the single crystal is used as a piezoelectric element.

In addition, the present invention is also directed to provision of an ultrasonic motor, an optical apparatus, a vibration device, a dust removing device, an image pickup apparatus, an ultrasonic probe, an ultrasonic diagnostic apparatus, an ultrasonic diagnostic system, and an electronic apparatus, which use a piezoelectric element having a larger piezoelectric constant and a larger mechanical quality factor.

[Solution to Problem]

In order to solve the above-mentioned problem, according to the present invention, there is provided a method of producing a single crystal by heating a matrix, the method including:

a first preparation step of preparing a matrix and a seed single crystal;
a second preparation step of preparing an integrated body in which a surface of the matrix and a surface of the seed single crystal are arranged in contact with each other;
a first temperature-increasing step of increasing a temperature of the integrated body from room temperature to a liquid-phase start temperature of the matrix;
a second temperature-increasing step of increasing the temperature of the integrated body from the liquid-phase start temperature to a liquid-phase end temperature of the matrix;
a heating step of heating the integrated body at the liquid-phase end temperature; and
a step of obtaining a single crystal from the integrated body after the heating,
wherein a rate of temperature increase in the second temperature-increasing step is lower than a rate of temperature increase in the first temperature-increasing step.

Further, according to the present invention, there is provided a single crystal including a perovskite-type oxide containing Ba, Ti, and Zr, and Mn,

wherein "x", which represents a molar ratio of the Zr to a sum of the Ti and the Zr, satisfies $0.01 \leq x \leq 0.13$, and
wherein a content of the Mn is 0.04 part by mass or more and 1.16 parts by mass or less in terms of metal with respect to 100 parts by mass of the oxide.

Further, according to the present invention, there is provided a piezoelectric element including a plurality of electrodes and the above-mentioned single crystal.
Further, according to the present invention, there is provided an ultrasonic motor including: a vibrating body including the above-mentioned piezoelectric element; and a moving body configured to be brought into contact with the vibrating body.
Further, according to the present invention, there is provided an optical apparatus including a drive unit including the above-mentioned ultrasonic motor.
Further, according to the present invention, there is provided a vibration device including a vibrating body including a diaphragm including the above-mentioned piezoelectric element.
Further, according to the present invention, there is provided a dust removing device including a vibration unit including the above-mentioned vibration device.
Further, according to the present invention, there is provided an image pickup apparatus including: the above-mentioned dust removing device; and an image pickup element unit, wherein a diaphragm of the above-mentioned dust removing device is provided on a light-receiving surface side of the image pickup element unit.
Further, according to the present invention, there is provided an ultrasonic probe including the above-mentioned piezoelectric element, the ultrasonic probe being configured to transmit and receive a signal by the piezoelectric element.
Further, according to the present invention, there is provided an ultrasonic diagnostic apparatus including the above-mentioned ultrasonic probe and an image output unit.
Further, according to the present invention, there is provided an ultrasonic diagnostic system including: the above-mentioned ultrasonic probe; a transmission unit configured to transmit a signal output from the above-mentioned ultrasonic probe; and a reception unit configured to receive the signal transmitted from the transmission unit.
Further, according to the present invention, there is provided an electronic apparatus including a piezoelectric acoustic component including the above-mentioned piezoelectric element.

[Advantageous Effects of Invention]

According to the present invention, a method of producing a single crystal, which can be applied to a wide range of material compositions, such as a composition containing a perovskite-type oxide containing Ba, Ti, and Zr, and Mn, which cannot be produced by related-art production methods, and a single crystal obtained by the method are provided.

[Brief Description of Drawings]

[Fig. 1]

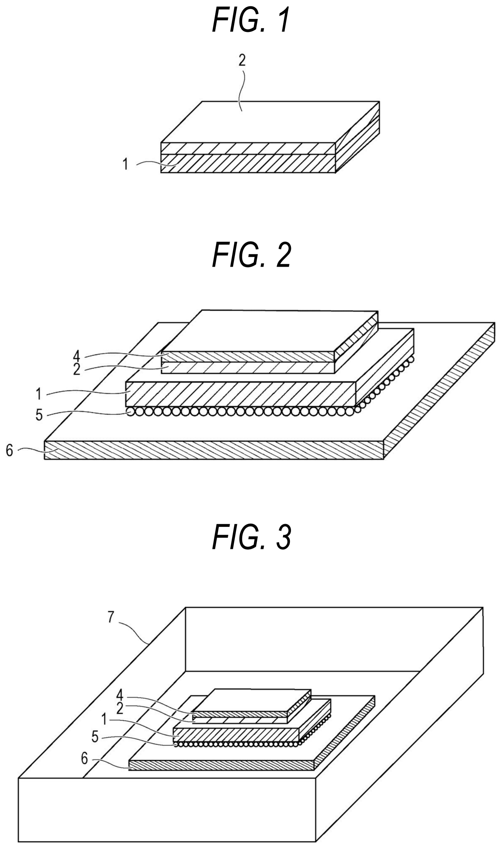

Fig. 1 is an explanatory schematic view for illustrating a first embodiment of the present invention.
[Fig. 2]
Fig. 2 is an explanatory schematic view for illustrating the first embodiment of the present invention.
[Fig. 3]
Fig. 3 is an explanatory schematic view for illustrating the first embodiment of the present invention.
[Fig. 4]

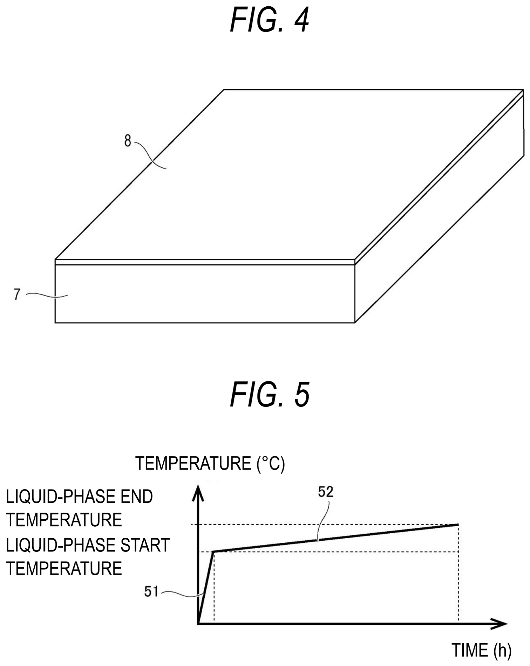

Fig. 4 is an explanatory schematic view for illustrating the first embodiment of the present invention.
[Fig. 5]

Fig. 5 is an explanatory schematic graph for showing a temperature increase profile of heat treatment in the first embodiment of the present invention.

[Fig. 6]

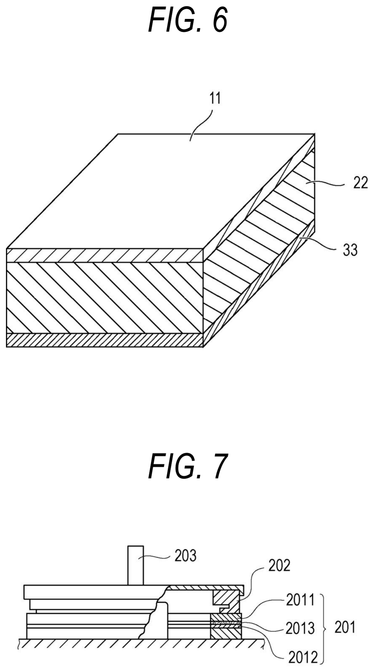

Fig. 6 is a schematic view for illustrating the configuration of a piezoelectric element according to one embodiment of the present invention.

[Fig. 7]

Fig. 7 is a schematic view for illustrating the configuration of an ultrasonic motor according to one embodiment of the present invention.

[Fig. 8A]

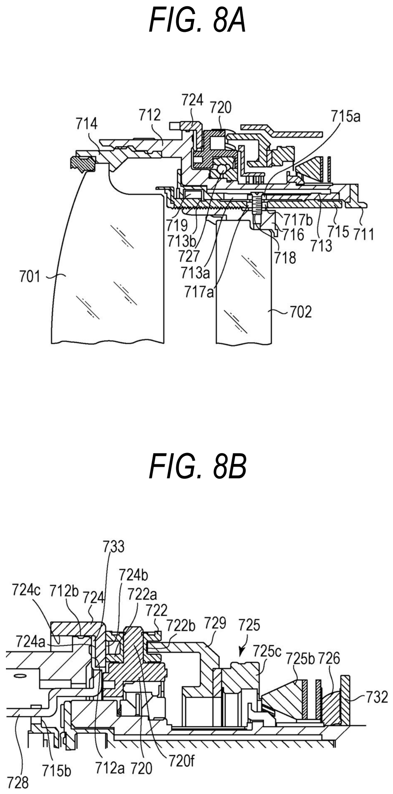

Fig. 8A is a schematic view for illustrating an optical apparatus according to one embodiment of the present invention.

[Fig. 8B]

Fig. 8B is a schematic view for illustrating the optical apparatus according to another one embodiment of the present invention.

[Fig. 9]

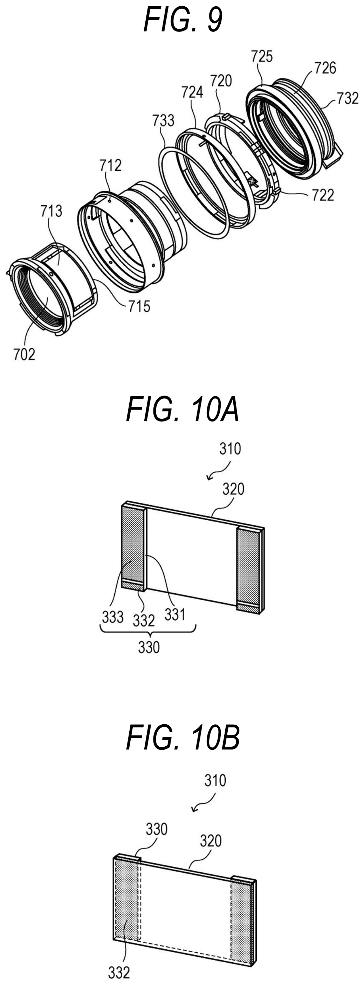

Fig. 9 is a schematic view for illustrating the optical apparatus according to one embodiment of the present invention.

[Fig. 10A]

Fig. 10A is a schematic view for illustrating one embodiment in which a vibration device of the present invention is used as a dust removing device.

[Fig. 10B]

Fig. 10B is a schematic view for illustrating another one embodiment in which the vibration device of the present invention is used as the dust removing device.

[Fig. 11A]

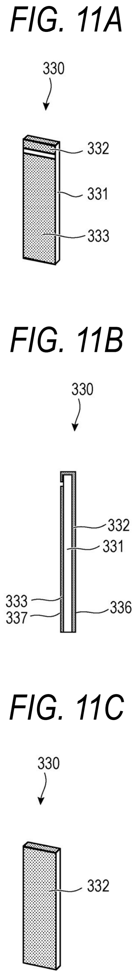

Fig. 11A is a schematic view for illustrating an example of the configuration of the piezoelectric element in the dust removing device of the present invention.

[Fig. 11B]

Fig. 11B is a schematic view for illustrating another example of the configuration of the piezoelectric element in the dust removing device of the present invention.

[Fig. 11C]

Fig. 11C is a schematic view for illustrating another example of the configuration of the piezoelectric element in the dust removing device of the present invention.

[Fig. 12A]

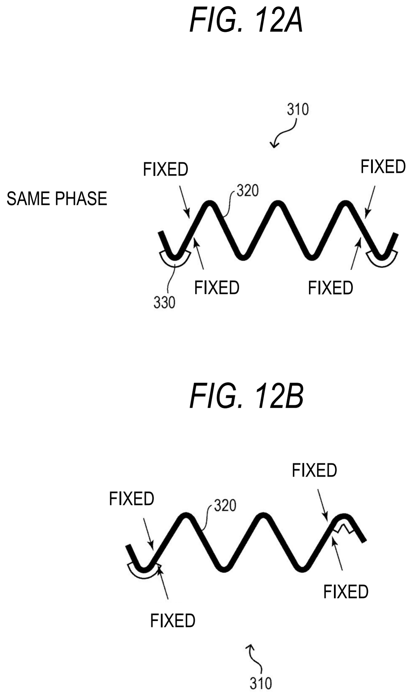

Fig. 12A is a schematic view for illustrating an example of the vibration principle of the dust removing device of the present invention.

[Fig. 12B]

Fig. 12B is a schematic view for illustrating another example of the vibration principle of the dust removing device of the present invention.

[Fig. 13]

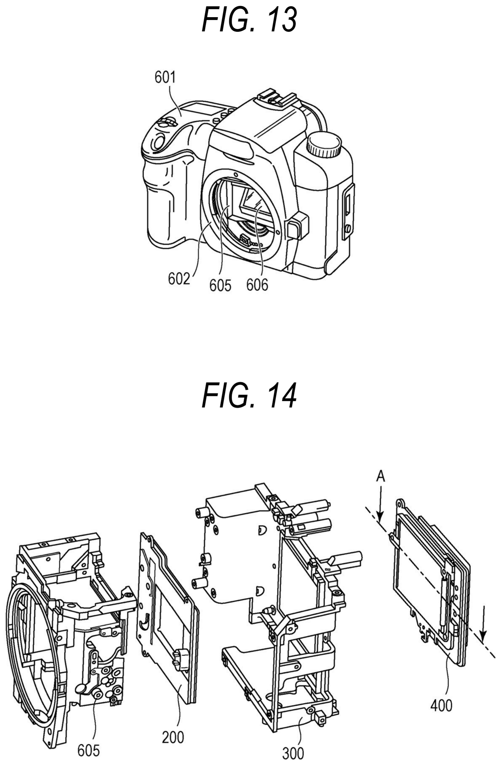

Fig. 13 is a schematic view for illustrating an image pickup apparatus according to one embodiment of the present invention.

[Fig. 14]

Fig. 14 is a schematic view for illustrating the image pickup apparatus according to one embodiment of the present invention.

[Fig. 15]

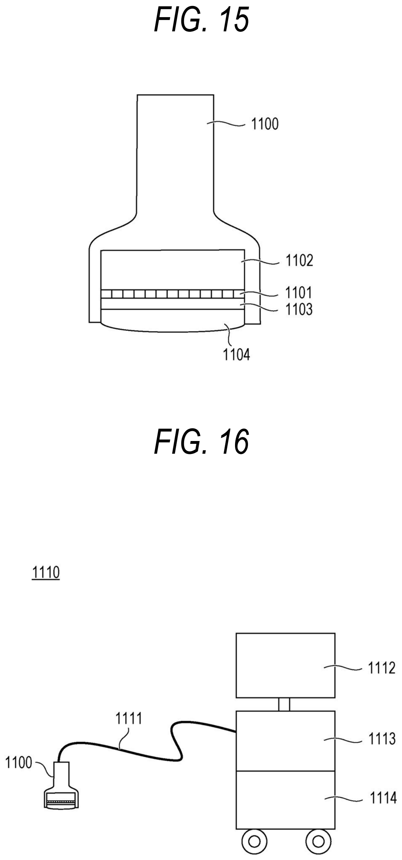

Fig. 15 is a schematic view for illustrating an ultrasonic probe according to one embodiment of the present invention.

[Fig. 16]

Fig. 16 is a schematic view for illustrating an ultrasonic diagnostic apparatus according to one embodiment of the present invention.

[Fig. 17]

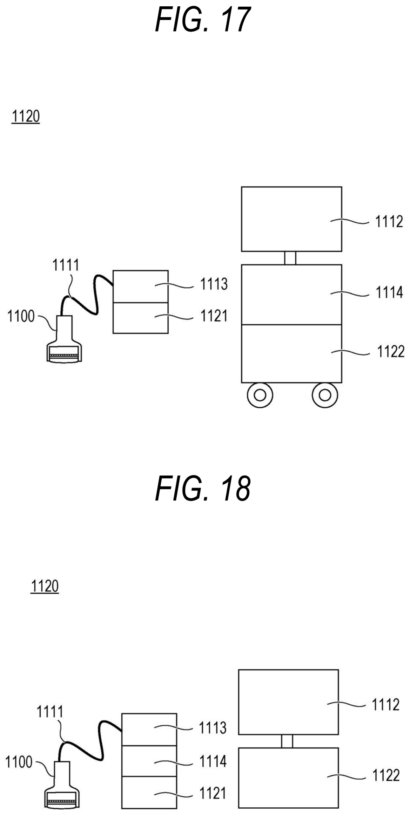

Fig. 17 is a schematic view for illustrating an ultrasonic diagnostic system according to one embodiment of the present invention.

[Fig. 18]

Fig. 18 is a schematic view for illustrating the ultrasonic diagnostic system according to one embodiment of the present invention.

[Fig. 19]

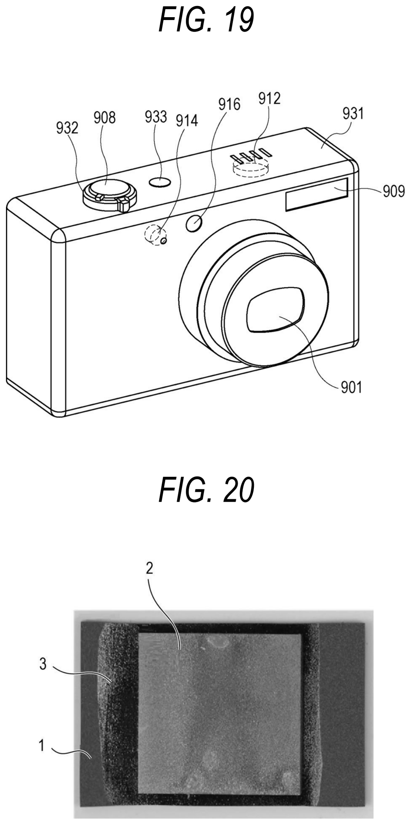

Fig. 19 is a schematic view for illustrating an electronic apparatus according to one embodiment of the present invention.

[Fig. 20]

Fig. 20 is an explanatory view for illustrating a state of a matrix after heat treatment in Examples of the present invention.

[Description of Embodiments]

Now, embodiments of the present invention are described.

The present invention provides a method of producing a single crystal that can be applied to a wide range of material compositions, and a single crystal obtained by the method.

In addition, the single crystal of the present invention can be used as a piezoelectric element for various applications, for example, electronic devices such as semiconductors, light-emitting elements, optical elements, energy conversion elements, and sensors.

<First Embodiment>

The first embodiment relates to a method of producing a single crystal.

The method of producing a single crystal of the present invention is a method of producing a single crystal by heating a matrix, the method including:

> a first preparation step of preparing a matrix and a seed single crystal;
> a second preparation step of preparing an integrated body in which a surface of the matrix and a surface of the seed single crystal are arranged in contact with each other;
> a first temperature-increasing step of increasing a temperature of the integrated body from room temperature to a liquid-phase start temperature of the matrix;
> a second temperature-increasing step of increasing the temperature of the integrated body from the liquid-phase start temperature to a liquid-phase end temperature of the matrix;
> a heating step of heating the integrated body at the liquid-phase end temperature; and
> a step of obtaining a single crystal from the integrated body after the heating.

A rate of temperature increase in the second temperature-increasing step is lower than a rate of temperature increase in the first temperature-increasing step.

Each item is described below together with description of basic matters for understanding the invention. Some substances such as a single crystal are also described in a second embodiment.

[Description 1 for understanding the Invention]

(Description of Single Crystal)

A single crystal is formed of a single crystal grain, and inside crystal grain, crystal axes, which represent direction of atomic arrangement, are all the same in any part. However, the single crystal of the present invention may contain lattice defects such as dislocations, vacancies, and voids inside the single crystal. In addition, the single crystal may contain a domain structure generated due to a difference in crystal system due to phase transition, a difference in direction of spontaneous polarization, etc.

(Perovskite-type)

The perovskite-type refers to a perovskite structure which is ideally a cubic structure, as described in the 5th edition of the Iwanami Physics and Chemical Dictionary (Iwanami Shoten, Publishers, published on February 20, 1998). A perovskite-type oxide is generally represented by the chemical formula $ABO_3$. Molar ratio of A-site and B-site elements to the O element is described as 1:3, but even in a case in which a ratio of element amounts slightly deviates therefrom (for example, from 1.00:2.94 to 1.00:3.06), when the oxide has a perovskite type as a main phase, the oxide can be said to be a perovskite-type oxide.

In addition, when the A element, the B element, and the O element are slightly shifted in coordinates from the symmetric position of the unit cell, the unit cell of the perovskite type is distorted, resulting in a crystal system such as tetragonal, rhombohedral, or orthorhombic. The single crystal of the present invention is preferably formed of a perovskite-type oxide, but the crystal system of the single crystal can be not only cubic but also tetragonal, rhombohedral, or orthorhombic depending on a single or a plurality of elements forming A and B. Whether the oxide is of a perovskite type and what the crystal system of the single crystal is can be determined, for example, by structural analysis by X-ray diffraction or electron beam diffraction. In this case, the sample may be pulverized before measurement as required.

Now, a specific method of producing the single crystal of the present invention is described.

Fig. 1 is a schematic view for illustrating an integrated body of a seed single crystal 2 and a matrix 1 in one embodiment of the present invention.

In Fig. 1, the seed single crystal 2 is provided on an upper portion of the matrix 1 to form an integrated body in which a surface of the matrix 1 and a surface of the seed single crystal 2 are arranged in contact with each other.

The method of producing a single crystal of the present invention is, for example, a method of producing a single crystal by heating the matrix 1 of the integrated body as illustrated in Fig. 1.

[First Preparation Step]

The method of producing a single crystal of the present invention includes a first preparation step of preparing the matrix 1 and the seed single crystal 2.

(Description of Matrix)

The matrix 1 of the present invention is preferably a compact or a sintered compact. The shape of the matrix 1 is not particularly limited, but a shape having a flat surface, such as a rectangular parallelepiped shape or a disk shape, is preferred because the matrix 1 is easy to arrange in contact with the seed single crystal 2.

(Raw Material Powder for producing Matrix)

The raw material used for the matrix 1 of the present invention is solid powder such as an oxide, carbonate, nitrate, or oxalate, containing constituent elements forming the single crystal of the present invention, or mixed powder thereof.

It is more preferred that a content of lead (Pb) contained in the raw material be less than 1,000 ppm because the load on the environment is small.

Examples of preferred elements forming the raw material of the matrix 1 include Li, Na, Mg, Al, Si, K, Ca, Sc, Ti, V, Cr, Mn, Fe, Co, Zn, Ge, Sr, Y, Zr, Nb, Mo, Sn, Sb, Ba, Hf, Ta, Bi, La, Nd, Sm, Eu, Gd, Tb, Dy, Ho, Er, and Yb.

The above-mentioned raw material may have been subjected to heat treatment for a purpose of homogenization, and may have been crushed after the heat treatment. The heat treatment for homogenizing the raw material is preferably performed within a range of 800°C or more and 1,300°C or less because the raw material is easy to crush after the heat treatment.

When the single crystal of the present invention is to be produced, a general method of producing a compact from solid powder such as an oxide, carbonate, nitrate, oxalate, or acetate, containing constituent elements, to sinter the compact under normal pressure can be adopted. The raw material is formed of compounds such as a Ba compound, a Ti compound, a Zr compound, a Mn compound, and a Bi compound.

Examples of usable Ba compounds include barium oxide, barium carbonate, barium oxalate, barium acetate, barium nitrate, barium titanate, and barium zirconate. It is preferred to use a high-purity type (for example, purity of 99.99% or more) of the Ba compound that is commercially available, as those Ba compounds.

Examples of usable Ti compounds include titanium oxide, barium titanate, and barium zirconate titanate. When those Ti compounds contain an alkaline earth metal such as barium, it is preferred to use a high-purity type (for example, purity of 99.99% or more) of the compound that is commercially available.

Nb in such an amount to be contained as an unavoidable component in a commercially available raw material of Ti, and Hf in such an amount to be contained as an unavoidable component in a commercially available raw material of Zr may be contained.

Examples of usable Zr compounds include zirconium oxide, barium zirconate, and barium zirconate titanate. When those Zr compounds contain an alkaline earth metal such as barium, it is preferred to use a high-purity type (for example, purity of 99.99% or more) of the compound that is commercially available.

Examples of usable Mn compounds include manganese carbonate, manganese oxide, manganese dioxide, manganese acetate, and trimanganese tetraoxide.

Examples of usable Bi compounds include bismuth trioxide, bismuth nitrate, bismuth fluoride, bismuth carbonate, and bismuth hydroxide.

In addition, the raw material for adjusting "a", which represents a ratio of a presence amount of Ba at the A site to a molar amount of Ti and Zr at the B site in a piezoelectric material according to the present invention, is not particularly limited. The effect is same for any of a Ba compound, a Ti compound, and a Zr compound.

(Granulation of Raw Material for producing Matrix)

The raw material of the matrix 1 used in the method of producing a single crystal of the present invention may be granulated, and the granulation method is not particularly limited. Examples of a binder that can be used during granulation include PVA (polyvinyl alcohol), PVB (polyvinyl butyral), and an acrylic resin. An amount of the binder to be added to the mixed powder is preferably from 1 part by mass to 10 parts by mass, more preferably from 2 parts by mass to 5 parts by mass from a viewpoint of increasing the density of the compact. The most preferred granulation method is a spray-drying method from the viewpoint that the grain diameter of the granulated powder can be made more uniform.

(Compact of Raw Material for producing Matrix)

The compact of the matrix 1 used in the method of producing a single crystal of the present invention is a compact obtained by solidifying the above-mentioned raw material into a desired shape, and the production method thereof is not particularly limited. The compact is a solid produced from raw material powder, granulated powder (binder), or slurry.

As means for producing the compact, uniaxial pressing, cold isostatic pressing, hot isostatic pressing, slip casting, extrusion molding, etc. can be used. In addition, the raw material in a slurry state may be formed into a sheet shape by using a doctor blade method and dried, and the sheets may be stacked to be molded into a target shape. When the sheet is subjected to a deaeration step before drying, the density increases so that the density of the matrix 1 using the sheet also increases, and hence the density of the single crystal produced using the matrix 1 also increases, which is preferred.

It is preferred that the matrix 1 in the method of producing a single crystal of the present invention be a compact. Furthermore, it is preferred that the matrix 1 is a polycrystal containing elements forming the single crystal produced by the method of producing a single crystal of the present invention. With such a configuration, a single crystal with a large area can be obtained. Also in this case, as illustrated in Fig. 1, it is only required that the seed single crystal 2 be placed on the matrix 1, and the matrix 1 and the seed single crystal 2 be arranged in contact with each other. When heat treatment is performed under such a state, the matrix 1 shrinks and the seed single crystal 2 slightly bites into the matrix 1 so that the matrix 1 and the seed single crystal 2 are brought into closer contact. That is, the contact area between the matrix 1 and the seed single crystal 2 increases.

A method of putting the seed single crystal 2 into the compact in molding is available, but the method has a risk of large deformation, break, or a crack due to the difference in shrinkage amount between the compact and the seed single crystal 2 during heat treatment. Accordingly, when the matrix 1 is a compact, it is preferred that the seed single crystal 2 is arranged in contact with each surface of the matrix 1.

It is preferred that the matrix 1 and the seed single crystal 2 is arranged vertically so as to be in contact with each other. Furthermore, it is preferred to place a weight on the matrix 1 and the seed single crystal 2 because the matrix 1 and the seed single crystal 2 are likely to be brought into contact with each other. Even when a force in a direction in which the matrix 1 and the seed single crystal 2 are separated from each other acts due to deformation during heat treatment, a force in a direction of suppressing the above-mentioned force acts due to the weight so that the matrix 1 and the seed single crystal 2 are more likely to be brought into contact with each other.

It is preferred that the area of the surface of the seed single crystal 2 on the side in contact with the matrix 1 is equal to or less than the area of the surface of the matrix 1 on the side in contact with the seed single crystal 2. The portion of the seed single crystal 2 larger than the matrix 1 does not contribute to the single crystallization of the matrix 1, and hence is wasted. Accordingly, it is preferred that the seed single crystal 2 is as small as possible.

However, when the seed single crystal 2 is excessively small, the heat treatment time for expanding the single crystal region to the entire matrix becomes long. Accordingly, it is preferred that the area of the surface of the seed single crystal 2 on the side in contact with the matrix 1 be 50% or more and 100% or less of the area of the surface of the matrix 1 on the side in contact with the seed single crystal 2.

(Sintering)

When the matrix 1 is used as a sintered compact, the above-mentioned compact may be sintered, and means for the sintering is not limited. Examples of the sintering method include sintering using an electric furnace, sintering using a gas furnace, a hot pressing method, a conduction heating method, a microwave sintering method, a millimeter-wave sintering method, hot isostatic pressing (HIP), and a flash sintering method. A hot pressing method, a conduction heating method, HIP, etc., which involves high pressure at high temperature, is preferred because voids in the matrix can be reduced in size or number. When the volume of voids in the matrix is small, the density of the single crystal obtained from the matrix 1 becomes large, which is preferred.

It is preferred that the relative density of the matrix 1 is 93% or more and 100% or less. When the relative density of the matrix 1 is 93% or more and 100% or less, the density of the single crystal obtained from the matrix 1 also becomes large.

The relative density is a ratio of the measured density to the theoretical density calculated from the lattice constant of the piezoelectric material and the atomic weight of the constituent elements of the piezoelectric material. The lattice constant can be measured, for example, by X-ray diffraction analysis. The density can be measured, for example, by the Archimedes method.

When the ratio of the measured density ($\rho$meas.) to the theoretical density ($\rho$calc.) obtained from the composition and lattice constant of the sintered compact, that is, the relative density ($\rho$calc./$\rho$meas.), is 93% or more, it can be said that the relative density is sufficiently high.

(Seed Single Crystal)

The seed single crystal 2 used in the method of producing a single crystal of the present invention may be a bulk or a thin film, but is preferably a bulk having a thickness of 10 $\mu$m or more in terms of high strength because stress may be generated in the seed single crystal 2 due to mismatch in lattice constant and a difference in thermal expansion between the seed single crystal 2 and the matrix 1 in a region in contact with the matrix 1, resulting in that there is a possibility of damage. In addition, it is preferred that the matrix 1 and the seed single crystal 2 have substantially the same composition. The seed single crystal 2 may be selected and prepared from commercially available oxide single crystals, semiconductor single crystals, fluoride/alkali halide single crystals, metal single crystals, alloy single crystals, etc., but a perovskite-type single crystal is preferred because stress due to mismatch in lattice constant and a difference in thermal expansion between the seed single crystal 2 and the matrix 1 is less liable to be generated.

It is preferred that the seed single crystal 2 used in the method of producing a single crystal of the present invention is a single crystal containing Ba, Ti, and Zr as main components. In addition, it is preferred that the seed single crystal 2 used in the method of producing a single crystal of the present invention is a single crystal containing Ba, Ti, and Ca as main components.

When the seed single crystal 2 is a single crystal containing Ba, Ti, and Zr as main components, or Ba, Ti, and Ca, the lattice constant and the linear expansion coefficient are close to those of the matrix 1 so that stress is less liable to be generated, and hence the produced single crystal is less liable to break, which is preferred.

Examples of the perovskite-type single crystal used as the seed single crystal 2 include $BaTiO_3$, $BaZrO_3$, $SrTiO_3$, $CaTiO_3$, $Pb(Mg_{1/3}Nb_{2/3})O_3$, $KTaO_3$, $KNbO_3$, $SrRuO_3$, $LiNbO_3$, $LaNiO_3$, $AgNbO_3$, $CdTiO_3$, and solid solutions thereof.

In addition, a single crystal obtained by the method of producing a single crystal of the present invention may be used as the seed single crystal 2 used in the production method of the present invention.

[Second Preparation Step]

The method of producing a single crystal of the present invention includes a second preparation step of preparing an integrated body in which the surface of the matrix 1 and the surface of the seed single crystal 2 are arranged in contact with each other.

(Polishing)

The method of producing a single crystal of the present invention preferably has a step of polishing the matrix 1 obtained by sintering as described above and the seed single crystal 2. When the polished surfaces of the matrix 1 and the seed single crystal 2 are arranged in contact with each other, to form an integrated body, the contact area can be further increased. It is preferred that the polished surface is a mirror surface because the contact area between the seed single crystal 2 and the matrix 1 can be further increased. When the matrix 1 is used as a compact, the surface of the mold used for producing the compact is preferably a mirror surface because the surface of the compact pressed by the surface of the mold also becomes a mirror surface.

Examples of a polishing method include mechanical polishing, chemical polishing, and CMP polishing, and those methods may be used in combination for polishing.

The mechanical polishing refers to polishing performed using a machine, and in the case of performing mechanical polishing, the machine may be selected and used from a polisher, a lapping machine, a polishing machine, and a buffing machine. In addition, a step using a precision grinding machine, etc. using a fine grindstone can also be a polishing step.

The chemical polishing is a polishing method in which a sample is immersed in a polishing solution and the surface of the sample is corroded by the chemical reaction by the action of acid or alkali. For example, the chemical polishing has a method of performing polishing by a rotary type in which a polishing pad is attached onto a disk-shaped surface plate, a polishing material of a liquid containing a chemical component and fine particles is dropped thereon, and polishing is performed while rotating the disk-shaped surface plate.

The CMP polishing is a method obtained by combining mechanical polishing and chemical polishing, in which, in addition to a mechanical action of abrasive grains scraping the surface of a sample, a chemical action occurs between the abrasive grains and the sample or with a polishing liquid or a grinding liquid, and the surface is planarized by the physical polishing and the chemical reaction.

A mirror surface can be produced by chemical polishing or CMP polishing.

(Saggar, Setter, Beads, Weight)

Fig. 2, Fig. 3, and Fig. 4 are examples of schematic views for illustrating configuration for producing a single crystal of the present invention. In Fig. 2, a weight 4 is placed on an integrated body of a matrix 1 and a seed single crystal 2, and the integrated body is provided on a setter 6 via beads 5. Fig. 3 shows those components placed in a saggar 7, and Fig. 4 shows the saggar 7 of Fig. 3 covered with a lid 8, and the saggar 7 covered with the lid 8 is placed in an electric furnace and heated.

It is preferred that the matrix 1 and the seed single crystal 2 are arranged vertically so as to be in contact with each other. Furthermore, it is preferred to place the weight 4 on the matrix 1 and the seed single crystal 2 because the matrix 1 and the seed single crystal 2 are likely to be brought into contact with each other. Even when a force in a direction in which the matrix 1 and the seed single crystal 2 are separated from each other acts due to deformation during heat treatment, a force in a direction to suppress the above-mentioned force acts due to the weight 4 so that the matrix 1 and the seed single crystal 2 are more likely to be brought into contact with each other.

When the matrix 1 is to be heated, it is preferred to put the matrix 1 and the seed single crystal 2 in the saggar 7 for heat treatment, and the saggar 7 is preferably a box shape with a lid because the matrix 1 and the seed single crystal 2 are less susceptible to the influence of, for example, furnace contamination.

The matrix 1 and the seed single crystal 2 are preferably placed on the setter 6 that does not easily react with the matrix 1 or the seed single crystal to be subjected to heat treatment. As the material for the setter 6, for example, alumina, zirconia, alumina coated with zirconia on the surface, stabilized zirconia, silicon carbide, or silicon nitride may be used. Beads 5 such as stabilized zirconia, powder obtained by sintering and pulverizing the matrix 1 at a high temperature, a platinum sheet, etc. may be placed on the setter 6, and the matrix 1 and the seed single crystal 2 may be placed thereon. When it is difficult to determine whether or not it is difficult to react, it is sufficient to actually try each material and select the material with the least traces left after heating.

[Description 2 for understanding the Invention]

(Liquid Phase of Matrix)

The matrix 1 used in the method of producing a single crystal of the present invention has a liquid-phase start temperature and a liquid-phase end temperature.

(Liquid Phase)

The liquid phase in the present invention refers to a state in which at least a part of the matrix 1 is in a liquid phase, and a state in which a solid phase and a liquid phase coexist is also a liquid phase. The state and temperature can be confirmed, for example, by placing a sample on a heating stage for a microscope (manufactured by Linkam Scientific Instruments Ltd.) and increasing the temperature, and observing the surface of the matrix 1 with a microscope. Specifically, the temperature at which at least a part of the grain boundaries of the matrix 1 can no longer be confirmed during the temperature increase is the liquid-phase start temperature, and the temperature at which at least a part of the grain boundaries of the matrix 1 is generated when the temperature is further increased is the liquid-phase end temperature.

As another means, due to a fact that the liquid phase becomes amorphous when being rapidly cooled, the temperature of the matrix 1 is increased to near the liquid phase temperature, and the heated matrix 1 is put into tap water at room temperature, etc. to be rapidly cooled, and then the structure is analyzed by X-ray diffraction. Thus, the temperature at which the liquid phase is formed can be confirmed by presence or absence of an amorphous region.

However, the liquid-phase start temperature in the present invention varies due to the influence of contamination of impurities in the preparation step, pressure unevenness during molding, voids, etc. Accordingly, a range within ±50°C of the lowest temperature at which a liquid phase can be confirmed by the above-mentioned means is defined as the liquid-phase start temperature. In addition, a range within ±50°C of the highest temperature at which a liquid phase can be confirmed by the above-mentioned means is defined as the liquid-phase end temperature.

When an interface between the seed single crystal 2 and the matrix 1 becomes a liquid phase, the interface of the region that is a single crystal of the seed single crystal 2 gradually expands toward the matrix 1 side. In this case, it is conceived that the crystal grains of the matrix 1 are incorporated into the single crystal due to the difference in surface energy. Accordingly, when the crystal grains of the matrix 1 are excessively large, the difference in surface energy becomes small, and hence it becomes difficult for the matrix 1 to be incorporated into the single crystal.

Accordingly, when the matrix 1 is prepared as a sintered compact, it is preferred to sinter the matrix 1 at a temperature at which the crystal grains do not become excessively large during sintering. As means for preventing an increase in size of the crystal grains, a method of performing sintering by setting the atmosphere during heating to a reducing atmosphere such as nitrogen or argon may be used. When the matrix 1 is used as a sintered compact, the grain diameter of the crystal grains of the matrix 1 is preferably 50 $\mu$m or less, more preferably 10 $\mu$m or less.

The "grain diameter" as used herein represents a "projected area equivalent circle diameter" generally referred to in a microscopic observation method, and represents a diameter of a perfect circle having a same area as that of the projected area of the crystal grain. In the present invention, the method of measuring the grain diameter is not particularly limited. For example, the grain diameter can be obtained by subjecting a photographic image, which is obtained by photographing the surface of a sample with a polarizing microscope or a scanning electron microscope, to image processing. The optimum magnification varies depending on a target grain diameter, and hence an optical microscope and an electron microscope may be used properly depending on the case. The equivalent circle diameter may be obtained from an image of a polished surface or a cross section instead of the surface of the sample.

(Heating Method)

In the first temperature-increasing step, the second temperature-increasing step, and the heating step, which are described later, the method of heating the integrated body of the matrix 1 and the seed single crystal 2 is not particularly limited, but sintering using an electric furnace is preferred in that a large number of integrated bodies can be heated at once so that production costs can be suppressed.

[First Temperature-increasing Step]

Fig. 5 is a schematic graph for showing a temperature-increasing step of the method of producing a single crystal of the present invention.

As shown in Fig. 5, the method of producing a single crystal of the present invention includes a first temperature-increasing step 51 of increasing the temperature of the integrated body from room temperature to the liquid-phase start temperature of the matrix.

In the first temperature-increasing step 51 of increasing the temperature to the liquid-phase start temperature, substantially uniform crystal grain growth is performed in the matrix. As described above, when the crystal grains of the matrix 1 become excessively large, it becomes difficult for the matrix 1 to be incorporated into the single crystal. Thus, it is preferred to perform the first temperature-increasing step 51 in a short time so that the crystal grains do not become excessively large.

(Atmosphere)

In this case, when the atmosphere during heating contains oxygen, the liquid phase is more likely to spread so that a larger single crystal can be produced more quickly. Accordingly, it is preferred that the atmosphere during heating contain oxygen.

(Numerical Limitation of First Rate of Temperature Increase)

It is preferred that a rate of temperature increase in the first temperature-increasing step 51 in the method of producing a single crystal of the present invention be 100°C or more per hour on a time average.

When the average rate of temperature increase in the first temperature-increasing step 51 is 100°C or more per hour on a time average, more preferably 150°C or more per hour on a time average, the crystal grains in the matrix 1 do not become excessively large in the first temperature-increasing step 51, and hence a single crystal formed of a single crystal grain can be more stably grown from the seed single crystal 2.

[Second Temperature-increasing Step]

In addition, as shown in Fig. 5, the method of producing a single crystal of the present invention includes a second temperature-increasing step 52 of increasing the temperature of the integrated body from the liquid-phase start temperature to the liquid-phase end temperature of the matrix. The atmosphere is same as that in the first temperature-increasing step 51, and hence description thereof is omitted.

In the second temperature-increasing step 52, the interface between the seed single crystal 2 and the matrix 1 becomes a liquid phase, and the single crystal interface expands toward the matrix 1 side. However, in a case of a composition that differs in the temperature depending on the location due to a difference in the orientation of the crystal grains of the matrix 1 in contact with the seed single crystal 2, the interfaces of the crystal grains of different orientations in the matrix 1 also expand at a same time, and hence a single crystal that is a single crystal grain is not obtained in some cases.

Accordingly, with a rate of temperature increase from the liquid-phase start temperature to the liquid-phase end temperature in the second temperature-increasing step 52 being made smaller than the rate of temperature increase from room temperature to the liquid-phase start temperature in the first temperature-increasing step 51, a single crystal formed of a single crystal grain can be grown from the seed single crystal 2.

After the temperature increase, with the single crystal being kept at the liquid-phase end temperature, the single crystal grown from the seed single crystal 2 can be further enlarged.

(Numerical Limitation of Second Rate of Temperature Increase)

In the method of producing a single crystal of the present invention, a rate of temperature increase in the second temperature-increasing step 52 is smaller than a rate of temperature increase in the first temperature-increasing step 51.

It is preferred that a rate of temperature increase in the second temperature-increasing step 52 in the method of producing a single crystal of the present invention be 1°C or less per hour on a time average.

When the average rate of temperature increase in the second temperature-increasing step 52 is 1°C or less per hour on a time average, more preferably 0.65°C or less per hour on a time average, a single crystal formed of a single crystal grain can be more stably grown from the seed single crystal 2, which is preferred.

[Heating Step]

The method of producing a single crystal of the present invention includes a heating step of heating the integrated body at the liquid-phase end temperature. The heating method is as described above. It is preferred that the heating step be performed continuously after the second temperature-increasing step, and the heating time for heating at the liquid-phase end temperature is preferably from 250 hours to 350 hours, more preferably about 300 hours. With such a configuration, a single crystal with a large area can be grown.

[Step of obtaining Single Crystal]

The method of producing a single crystal of the present invention includes a step of obtaining a perovskite-type single crystal from the integrated body after heating.

After the second temperature-increasing step, which region in the matrix is a single crystal can be confirmed by checking whether the region has a grain boundary with a microscope. When the region has no grain boundary, the region is a single crystal formed of a single crystal grain. In addition, confirmation can also be made using structural analysis by X-ray diffraction or electron beam diffraction.

When the polycrystalline portion and the seed single crystal 2 portion other than the single crystal region are removed by a wire saw, a dicing saw, water jet cutting, electric discharge machining, laser processing, polishing, etc., only the single crystal region can be obtained.

Also in the case of the integrated body being kept at the liquid-phase end temperature for a certain period of time after the second temperature-increasing step, a single crystal can be obtained from the matrix 1 by a same method.

It is preferred that the single crystal of the present invention contain Ba, Ti, Zr, and Mn, and with such a configuration, a perovskite-type single crystal can be stably obtained. In particular, when the single crystal contains both Zr and Mn with respect to Ba and Ti, abnormal grain growth is less liable to occur in portions other than the interface between the seed single crystal 2 and the matrix 1. When abnormal grain growth occurs in a portion other than the seed single crystal 2 and the matrix 1, the portion hinders the growth of the single crystal spreading from the interface between the seed single crystal 2 and the matrix 1.

It is preferred that the single crystal of the present invention is a single crystal containing a perovskite-type oxide containing Ba, Ti, and Zr, and Mn, and "x", which represents a molar ratio of Zr to a sum of Ti and Zr, satisfy $0.01 \leq x \leq 0.13$, and the content of the Mn be 0.04 part by mass or more and 1.16 parts by mass or less in terms of metal with respect to 100 parts by mass of the oxide. With such a configuration, abnormal grain growth is less liable to occur in portions other than the interface between the seed single crystal 2 and the matrix 1.

<Second Embodiment>

The second embodiment relates to a single crystal.

The single crystal of the present invention is a single crystal containing a perovskite-type oxide containing Ba, Ti, and Zr, and Mn.

"x", which represents a molar ratio of the Zr to a sum of the Ti and the Zr, satisfy $0.01 \leq x \leq 0.13$.

The content of the Mn is 0.04 part by mass or more and 1.16 parts by mass or less in terms of metal with respect to 100 parts by mass of the oxide.

Herein, the content of Mn in "terms of metal" indicates the following. The content of each metal of Ba, Ti, Zr, and Mn is measured from the single crystal by X-ray fluorescence analysis (XRF), inductively coupled plasma (ICP) emission spectrometry, atomic absorption spectrometry, etc. From the content, the elements forming the oxide represented by the following general formula (1) are converted into oxides, and the total mass is defined as 100. The content of Mn indicates a value obtained as a ratio of the mass of Mn to the total mass.

$$Ba_a(Ti_{1-x}, Zr_x)O_3 \qquad (1)$$

The single crystal containing a perovskite-type oxide containing Ba, Ti, and Zr and Mn has piezoelectricity, and has a high piezoelectric constant and a high mechanical quality factor among piezoelectric materials using no lead. The single crystal of the present invention uses lead, and hence the load on the environment is small.

When a single crystal having piezoelectricity is used in a resonance device such as an ultrasonic motor, a large mechanical quality factor representing the sharpness of resonance is required. When the mechanical quality factor is small, the power required for operation becomes high, or the piezoelectric element generates heat, making drive control difficult. Accordingly, a single crystal with a large mechanical quality factor is required. In addition, when the piezoelectric constant of the single crystal is small, it is required to increase the drive voltage in order to obtain the required vibration amplitude, and when the drive voltage is increased, a large current due to the capacitance component as a dielectric of the material flows, resulting in high power consumption.

The oxide represented by the general formula (1) means that the element located at the A site is Ba, and the elements located at the B site are Ti and Zr. However, part of Ba may be located at the B site. Similarly, part of Ti and Zr may be located at the A site.

In the general formula (1), the molar ratio of the B-site elements to the O element is 1:3, but the ratio of the element amounts may slightly deviate therefrom (for example, from 1.00:2.94 to 1.00:3.06).

In the single crystal of the present invention, it is preferred that "a", which represents the ratio of the molar amount of Ba at the A site to the molar amount of Ti and Zr at the B site in the general formula (1), fall within a range of $0.965 \leq a \leq 1.020$.

It is preferred that the single crystal of the present invention contain 90 mol% or more of a perovskite-type oxide represented by the general formula (1), as a main component. A more preferred range is 95 mol% or more. When "a" is less than 0.965, a large number of voids are generated, resulting in that the strength may be reduced. Meanwhile, when "a" becomes larger than 1.020, the grain diameter of the matrix 1 becomes excessively large in the first temperature-increasing step so that the region of the single crystal is less likely to expand during heating, resulting in that it may be difficult to produce a single crystal.

A preferred range of "a" in which voids become small and the region of the single crystal is likely to expand during heating is $0.985 \leq a \leq 1.000$.

In the general formula (1), "x", which represents the molar ratio of Zr at the B site, falls within a range of $0.01 \leq x \leq 0.13$. When "x" is larger than 0.13, the Curie temperature becomes excessively low so that the high-temperature durability becomes insufficient, and when "x" is smaller than 0.01, the piezoelectric constant at room temperature becomes small.

The Curie temperature (Tc) refers to the temperature at which the ferroelectricity of a material disappears. Generally, the piezoelectricity of a piezoelectric material also disappears at or above the Tc. A method of measuring the Tc includes a method of directly measuring the temperature at which ferroelectricity disappears while changing the measurement temperature, and a method of measuring the relative permittivity while changing the measurement temperature through use of a minute AC electric field to obtain the Tc from the temperature at which the relative permittivity becomes maximum.

The means for measuring the composition of the single crystal of the present invention is not particularly limited. Examples of the means include X-ray fluorescence analysis, ICP emission spectrometry, and atomic absorption spectrometry. In any of the means, mass ratio and composition ratio of each element contained in the single crystal can be calculated.

When the single crystal of the present invention contains Mn within the above-mentioned range, the mechanical quality factor in a room temperature region is improved. Herein, mechanical quality factor is a coefficient representing the elastic loss due to vibration when a piezoelectric material is evaluated as a vibrator, and magnitude of the mechanical quality factor is observed as the sharpness of a resonance curve in impedance measurement. That is, the mechanical quality factor is a constant representing the sharpness of the resonance of the vibrator. The higher the mechanical quality factor, the less energy is lost by vibration. Accordingly, when the mechanical quality factor is improved, the power consumption when the single crystal is driven by applying a voltage as a piezoelectric element becomes small.

When the content of Mn is less than 0.04 part by mass, the mechanical quality factor in the room temperature region becomes as small as less than 150. When the mechanical quality factor is small, the power consumption increases when a piezoelectric element including the single crystal and a pair of electrodes is driven as a resonance device. The mechanical quality factor is preferably 200 or more, more preferably 400 or more. The mechanical quality factor is still more preferably 700 or more. Within such ranges, an extreme increase in power consumption does not occur during device operation. Meanwhile, when the content of Mn is larger than 1.16 parts by mass, the insulation property of the single crystal deteriorates. For example, the dielectric loss tangent of the single crystal at a frequency of 1 kHz may exceed 0.01, or the resistivity may fall below 1 GΩcm. The dielectric loss tangent can be measured using an impedance analyzer. When the dielectric loss tangent is 0.01 or less, stable operation can be obtained even when a high voltage is applied using the single crystal as a piezoelectric element.

When the resistivity of the single crystal is 1 GΩcm, the polarization can be performed, and hence the single crystal can be driven as a piezoelectric element. A more preferred resistivity is 50 GΩcm or more.

Mn is not limited to metal Mn, is only required to be contained in the single crystal as a Mn component, and may be contained in any form. For example, Mn may be formed into a solid solution at the B site or may be contained in the interface with voids in the single crystal. Alternatively, the Mn component may be contained in the single crystal in the form of a metal, an ion, an oxide, a metal salt, a complex, etc. More preferably, Mn is present from viewpoints of an insulation property and ease of sintering. In general, the valence of Mn may be 4+, 2+, or 3+. The reason for this is as described below. When a conduction electron is present in a crystal (for example, when an oxygen defect is present in the crystal, when the A site is occupied by a donor element, etc.), the valence of Mn is decreased from 4+ to 3+, 2+, etc., and thus the conduction electron is trapped, with a result that the insulation resistance can be improved.

Meanwhile, when the valence of Mn is less than 4+ such as 2+, Mn becomes an acceptor. When Mn is present in a single crystal of a perovskite type as an acceptor, holes are generated in the crystal or oxygen vacancies are formed in the single crystal.

When the valence of Mn added in a large amount is 2+ or 3+, the holes cannot be fully compensated merely by the introduction of the oxygen vacancies, and the insulation resistance is decreased. Accordingly, most of Mn preferably has a valence of 4+. However, a significantly small amount of Mn may have a valence of less than 4+ and occupy the B site of the perovskite structure as an acceptor to form oxygen vacancies. This is because Mn having a valence of 2+ or 3+ and oxygen vacancies can form defective dipoles to improve the mechanical quality factor of the single crystal. When trivalent Bi occupies the A site, Mn easily has a valence of less than 4+ in order to achieve charge balance.

The valence of Mn added in a slight amount to a non-magnetic (diamagnetic) material may be evaluated by measuring the temperature dependence of magnetic susceptibility. The magnetic susceptibility may be measured with a superconducting quantum interference device (SQUID), a vibrating-sample magnetometer (VSM), or a magnetic balance. The magnetic susceptibility $\chi$ obtained by the measurement generally follows the Curie-Weiss law represented by Expression 2.

$$(\text{Expression 2}) \quad \chi = C/(T-\theta)$$

(C: Curie constant, $\theta$: paramagnetic Curie temperature)

In general, Mn added in a slight amount to a non-magnetic material shows a spin S of 5/2 when having a valence of 2+, a spin S of 2 when having a valence of 3+, and a spin S of 3/2 when having a valence of 4+. Accordingly, the Curie constant C converted per unit Mn amount becomes a value corresponding to the value of the spin S at each valence of Mn. Thus, the average valence of Mn in the sample can be evaluated by deriving Curie constant C from temperature dependence of magnetic susceptibility $\chi$.

(Longest Part)

It is preferred that the longest part of the single crystal of the present invention is 1 mm or more and 100 mm or less.

With the longest part being set to fall within this range, the single crystal can be applied to a wide range of devices. When the longest part is 1 mm or more, processing becomes easy. In addition, when the longest part exceeds 100 mm, it takes a very long time to produce a single crystal, and hence it is preferred that the longest part fall within 100 mm in terms of production cost.

(Relative Density)

It is preferred that the relative density of the single crystal of the present invention be 93% or more and 100% or less.

When the relative density is less than 93%, the mechanical strength may decrease.

A more preferred relative density of the piezoelectric material of the present invention falls within a range of 95% or more and 100% or less, and a further preferred relative density falls within a range of 97% or more and 100% or less. When the relative density is 95% or more, it is less liable to be damaged during processing, and when it is 97% or more, chipping during cutting and polishing is reduced.

(Mechanical Quality Factor)

It is preferred that the single crystal of the present invention have a mechanical quality factor Qm of 500 or more.
When the mechanical quality factor of the single crystal is 500 or more, the power required for driving becomes small so that the heat generation of the single crystal can be suppressed.

(Tetragonal Single Crystal)

It is preferred that, in the single crystal of the present invention, "x", which represents a molar ratio of the Zr to a sum of the Ti and the Zr, satisfy $0.01 \leq x \leq 0.03$, "a", which represents a molar ratio of Ba to the sum of the Ti and the Zr, satisfy $0.976 \leq a \leq 1.020$, the single crystal further contain Bi, and the content of the Bi is 0.04 part by mass or more and 0.53 part by mass or less in terms of metal with respect to 100 parts by mass of the oxide.
When a single crystal having piezoelectricity is used in a device such as an ultrasonic motor, it is preferred that the coercive electric field indicating the withstand voltage be large (for example, 2.5 kV/cm or more), and a single crystal with a large coercive electric field is less liable to deteriorate in piezoelectric performance even when being driven at a high voltage.
The single crystal containing a perovskite-type oxide containing Ba, Ti, and Zr, and Mn and Bi has a large piezoelectric constant, a large mechanical quality factor, and a large coercive electric field among piezoelectric materials using no lead.
In the single crystal of the present invention, when Bi is contained in an amount of 0.04 part by mass or more and 0.53 part by mass or less with respect to 1 mol of the metal oxide, trivalent Bi can occupy the A site. Accordingly, Mn at the B site easily has a valence of less than 4+ in order to achieve charge balance, and hence an effect of improving the mechanical quality factor by Mn can be further enhanced.
In addition, in the general formula (1), "x", which represents the molar ratio of Zr at the B site, falls within a range of $0.01 \leq x \leq 0.03$. When "x" is 0.03 or less, the single crystal becomes a tetragonal system at room temperature of 25°C, coercive electric field is large, and hence the withstand voltage is excellent. When "x" is 0.01 or more, a high piezoelectric constant is obtained at room temperature of 25°C.
When the content of Mn in the single crystal of the present invention is 0.002 mol or more and 0.050 mol or less with respect to 1 mol of the metal oxide, the coercive electric field increases at room temperature of 25°C. As described above, when Mn having a valence of 2+ or 3+ and oxygen vacancies form defective dipoles, and hence an internal electric field is generated, the internal electric field prevents switching of the polarization caused by an external electric field so that the coercive electric field is improved.

<Application Examples>

Now, application examples of the present invention are described.

(Piezoelectric Element)

The piezoelectric element of the present invention includes a plurality of electrodes and the above-mentioned single crystal.
Fig. 6 is a schematic view for illustrating the configuration of a piezoelectric element according to one embodiment of the present invention. The piezoelectric element according to the present invention is characterized by including at least a first electrode 11, a single crystal portion 22, and a second electrode 33, in which the single crystal portion 22 is formed of the single crystal of the present invention.
The piezoelectric constant of the single crystal of the present invention may be evaluated by forming the piezoelectric element including at least the first electrode 11 and the second electrode 33. The first electrode 11 and the second electrode 33 are each formed of a conductive layer having a thickness of from about 5 nm to about 10 $\mu$m. A material therefor is not particularly limited, and is only required to be one to be generally used for a piezoelectric element. Examples thereof may include metals, such as Ti, Pt, Ta, Ir, Sr, In, Sn, Au, Al, Fe, Cr, Ni, Pd, Ag, and Cu, alloys, and compounds thereof.
Each of the first electrode 11 and the second electrode 33 may be formed of one kind of those materials, or may be obtained by stacking two or more kinds thereof. In addition, the first electrode 11 and the second electrode 33 may be formed of materials different from each other.

A manufacturing method for each of the first electrode 11 and the second electrode 33 is not limited. Those electrodes may each be formed by baking a metal paste or by sputtering, vapor deposition, etc. In addition, both the first electrode 11 and the second electrode 33 may be patterned in desired shapes.

(Polarization Treatment)

It is more preferred that the piezoelectric element have polarization axes aligned in a certain direction. When the polarization axes are aligned in a certain direction, the piezoelectric constant of the piezoelectric element is increased.

The polarization method of the piezoelectric element is not particularly limited. The polarization treatment may be performed in the air or in silicone oil. The temperature during polarization is preferably the temperature at which the single crystal undergoes phase transition. For example, a temperature of from 60°C to 150°C is preferred, but the optimum conditions slightly differ depending on the composition of the single crystal forming the element. The electric field applied for performing the polarization treatment is preferably from 8 kV/cm to 20 kV/cm, and it is preferred to decrease an environmental temperature to a temperature at which the single crystal has a same crystal structure as at room temperature, and then to terminate the application of the electric field, in order to obtain a satisfactory piezoelectric constant.

The piezoelectric element according to the present invention also includes a multilayered piezoelectric element in which a large number of single crystals of the present invention are stacked, or in which a large number of piezoelectric elements are stacked to form a rod shape so that displacement in the thickness direction is utilized.

(Ultrasonic Motor)

The ultrasonic motor of the present invention includes: a vibrating body including the above-mentioned piezoelectric element; and a moving body that is to be brought into contact with the vibrating body. With such a configuration, an ultrasonic motor having driving efficiency comparable to or higher than that in a case of using a piezoelectric element containing lead can be provided. Fig. 7 is a schematic view for illustrating the configuration of an ultrasonic motor according to one embodiment of the present invention. Fig. 7 shows an ultrasonic motor in which the piezoelectric element of the present invention is formed of a single plate. The ultrasonic motor includes: a vibrator 201; a rotor 202 that is in contact with a sliding surface of the vibrator 201 with a pressing force by a pressure spring (not shown); and an output shaft 203 provided integrally with the rotor 202. The vibrator 201 includes: a metal elastic ring 2011; a piezoelectric element 2012 of the present invention; and an organic adhesive 2013 for bonding the piezoelectric element 2012 to the elastic ring 2011 (such as an epoxy- or cyanoacrylate-based adhesive). The piezoelectric element 2012 of the present invention includes a single crystal sandwiched between a first electrode 11 (not shown) and a second electrode 33 (not shown). The application of two AC voltages different from each other in phase by an odd multiple of $\pi/2$ to the piezoelectric element of the present invention results in the generation of a flexural traveling wave in the vibrator 201, and hence each point on the sliding surface of the vibrator 201 undergoes an elliptical motion. When the rotor 202 is brought into press contact with the sliding surface of the vibrator 201, the rotor 202 receives a frictional force from the vibrator 201 to rotate in a direction opposite to a flexural traveling wave. A body to be driven (not shown) is joined to the output shaft 203, and is driven by the rotary force of the rotor 202. When a voltage is applied to the single crystal, the single crystal expands and contracts due to a transverse piezoelectric effect. The conversion efficiency from the electrical energy to the mechanical energy depends on the magnitude of the electromechanical coupling coefficient. When an elastic body such as a metal is bonded to a piezoelectric element by an adhesive, etc., the elastic body is bent by the expansion and contraction of the single crystal via the adhesive. The ultrasonic motor of the kind described in the foregoing utilizes this principle.

(Optical Apparatus)

The optical apparatus of the present invention includes a drive unit including the above-mentioned ultrasonic motor. With such a configuration, an optical apparatus having an operating speed and operating efficiency comparable to or higher than those in the case of using a piezoelectric element containing lead can be provided.

Fig. 8A and Fig. 8B are each a sectional view of main parts of an interchangeable lens barrel for a single-lens reflex camera as an example of an optical apparatus according to an exemplary embodiment of the present invention. In addition, Fig. 9 is an exploded perspective view of the interchangeable lens barrel for the single-lens reflex camera as the example of the optical apparatus according to the exemplary embodiment of the present invention. A fixed barrel 712, a linear guide barrel 713, and a front unit barrel 714 are fixed to an attaching/detaching mount 711 for a camera. Those members are fixed members of the interchangeable lens barrel.

A linear guide groove 713a in an optical axis direction for a focus lens 702 is formed on the linear guide barrel 713. Cam rollers 717a and 717b protruding outward in a radial direction are fixed to a rear unit barrel 716 holding the focus lens 702 via axial screws 718, and the cam roller 717a is fitted in the linear guide groove 713a.

A cam ring 715 is fitted on the inner periphery of the linear guide barrel 713 in a rotatable manner. Relative movement between the linear guide barrel 713 and the cam ring 715 in the optical axis direction is restricted because a roller 719 fixed to the cam ring 715 is fitted in an annular groove 713b of the linear guide barrel 713. A cam groove 715a for the focus lens 702 is formed on the cam ring 715, and the above-mentioned cam roller 717b is simultaneously fitted in the cam groove 715a.

On the outer peripheral side of the fixed barrel 712, there is arranged a rotation transmission ring 720 held by a ball race 727 in a rotatable manner at a constant position with respect to the fixed barrel 712. The rotation transmission ring 720 has shafts 720f extending radially from the rotation transmission ring 720, and rollers 722 are held by the shafts 720f in a rotatable manner. A large diameter part 722a of the roller 722 is brought into contact with a mount side end surface 724b of a manual focus ring 724. In addition, a small diameter part 722b of the roller 722 is brought into contact with a joining member 729. Six rollers 722 are arranged on the outer periphery of the rotation transmission ring 720 at regular intervals, and each roller is arranged in the relationship as described above.

A low friction sheet (washer member) 733 is arranged on an inner diameter part of the manual focus ring 724, and this low friction sheet is sandwiched between a mount side end surface 712a of the fixed barrel 712 and a front side end surface 724a of the manual focus ring 724. In addition, an outer diameter surface of the low friction sheet 733 is formed in a ring shape so as to be circumferentially fitted on an inner diameter part 724c of the manual focus ring 724. Further, the inner diameter part 724c of the manual focus ring 724 is circumferentially fitted on an outer diameter part 712b of the fixed barrel 712. The low friction sheet 733 has a role of reducing friction in a rotation ring mechanism in which the manual focus ring 724 rotates relatively to the fixed barrel 712 about the optical axis.

The large diameter part 722a of the roller 722 is brought into contact with the mount side end surface 724b of the manual focus ring under a state in which a pressure is applied by a pressing force of a waved washer 726 pressing an ultrasonic motor 725 to the front of the lens. In addition, similarly, the small diameter part 722b of the roller 722 is brought into contact with the joining member 729 under a state in which an appropriate pressure is applied by a pressing force of the waved washer 726 pressing the ultrasonic motor 725 to the front of the lens. Movement of the waved washer 726 in the mount direction is restricted by a washer 732 connected to the fixed barrel 712 by bayonet joint. A spring force (biasing force) generated by the waved washer 726 is transmitted to the ultrasonic motor 725, and further to the roller 722, to be a force for the manual focus ring 724 to press the mount side end surface 712a of the fixed barrel 712. In other words, the manual focus ring 724 is integrated under a state in which the manual focus ring 724 is pressed to the mount side end surface 712a of the fixed barrel 712 via the low friction sheet 733.

Accordingly, when a control unit (not shown) drives the ultrasonic motor 725 to rotate with respect to the fixed barrel 712, the rollers 722 rotate about the shafts 720f because the joining member 729 is brought into frictional contact with the small diameter parts 722b of the rollers 722. As a result of the rotation of the rollers 722 about the shafts 720f, the rotation transmission ring 720 rotates about the optical axis (automatic focus operation).

In addition, when a manual operation input portion (not shown) gives a rotation force about the optical axis to the manual focus ring 724, the following action occurs. That is, the rollers 722 rotate about the shafts 720f by friction force because the mount side end surface 724b of the manual focus ring 724 is brought into contact by pressure to the large diameter parts 722a of the rollers 722. When the large diameter parts 722a of the rollers 722 rotate about the shafts 720f, the rotation transmission ring 720 rotates about the optical axis. In this case, the ultrasonic motor 725 does not rotate because of a friction retaining force between a rotor 725c and a stator 725b (manual focus operation).

Two focus keys 728 are mounted to the rotation transmission ring 720 at opposing positions, and the focus key 728 is fitted to a notch portion 715b arranged on the tip of the cam ring 715. Accordingly, when the automatic focus operation or the manual focus operation is performed so that the rotation transmission ring 720 is rotated about the optical axis, the rotation force is transmitted to the cam ring 715 via the focus key 728. When the cam ring is rotated about the optical axis, the rear unit barrel 716 whose rotation is restricted by the cam roller 717a and the linear guide groove 713a is moved forward and backward along the cam groove 715a of the cam ring 715 by the cam roller 717b. Thus, the focus lens 702 is driven, and the focus operation is performed.

While the interchangeable lens barrel for the single-lens reflex camera has been described as the optical apparatus of the present invention, the optical apparatus of the present invention can be applied to any optical apparatus including the drive unit including the ultrasonic motor, regardless of a type of the camera, including a compact camera, an electronic still camera, a personal digital assistant with a camera, etc.

(Vibration Device and Dust Removing Device)

The vibration device of the present invention includes a vibrating body including a diaphragm including the above-mentioned piezoelectric element. With such a configuration, a vibration device having vibration ability comparable to or higher than that in the case of using a piezoelectric element containing lead can be provided.

A vibration device used, for example, for conveying and removing particles, powder, and droplets are widely used in an electronic apparatus, etc.

Now, as an example of the vibration device of the present invention, a dust removing device using the vibration device of the present invention is described.

The dust removing device according to the present invention includes a vibration unit including a vibration device. With such a configuration, a dust removing device having dust removing efficiency comparable to or higher than that in the case of using a piezoelectric element containing lead can be provided.

Fig. 10A and Fig. 10B are each a schematic view for illustrating a dust removing device according to one embodiment of the present invention. A dust removing device 310 includes plate-like piezoelectric elements 330 and a diaphragm 320. A material for the diaphragm 320 is not limited. When the dust removing device 310 is used for an optical device, a light transmissive material or a light reflective material may be used as the diaphragm 320.

Fig. 11A to Fig. 11C are schematic views for illustrating the configuration of the piezoelectric element 330 in Fig. 10A and Fig. 10B. Fig. 11A and Fig. 11C show the configuration of the front and back surfaces of the piezoelectric element 330, and Fig. 11B shows the configuration of the side surface. As illustrated in Fig. 10A, the piezoelectric element 330 includes a single crystal 331, a first electrode 332, and a second electrode 333, and the first electrode 332 and the second electrode 333 are arranged so as to be opposed to the plate surface of the single crystal 331.

In Fig. 11B, a surface on which the first electrode 332 protruding in front of the piezoelectric element 330 is installed is defined as a first electrode surface 336, and in Fig. 11A, a surface on which the second electrode 333 protruding in front of the piezoelectric element 330 is installed is defined as a second electrode surface 337.

Herein, the electrode surface in the present invention refers to the surface of the piezoelectric element on which the electrode is installed, and the first electrode 332 may wrap around the second electrode surface 337, for example, as illustrated in Fig. 11A and Fig. 11B.

As illustrated in Fig. 10A and Fig. 10B, in the piezoelectric elements 330 and the diaphragm 320, the first electrode surface 336 of each of the piezoelectric elements 330 is fixed to a plate surface of the diaphragm 320. Then, a stress is generated between the piezoelectric element 330 and the diaphragm 320 by driving the piezoelectric element 330, to thereby generate out-of-plane vibration in the diaphragm. The dust removing device 310 of the present invention is a device for removing foreign matter such as dust adhering to the surface of the diaphragm 320 through the out-of-plane vibration of the diaphragm 320. The out-of-plane vibration means elastic vibration that displaces the diaphragm into an optical axis direction, that is, a thickness direction of the diaphragm.

Fig. 12A and Fig. 12B are each a schematic view for illustrating the vibration principle of the dust removing device 310 of the present invention. In Fig. 12A, there is illustrated a state in which the out-of-plane vibration is generated in the diaphragm 320 by applying AC voltages having the same phase to a pair of left and right piezoelectric elements 330, respectively. The polarization direction of the single crystal forming the pair of left and right piezoelectric elements 330 is the same as the thickness direction of the piezoelectric elements 330, and the dust removing device 310 is driven in the seventh vibration mode. In Fig. 12B, there is illustrated a state in which the out-of-plane vibration is generated in the diaphragm 320 by applying AC voltages having opposite phases that are opposite by 180° to the pair of left and right piezoelectric elements 330, respectively. The dust removing device 310 is driven in the sixth vibration mode. The dust removing device 310 of the present invention is a device capable of effectively removing dust adhering to the surface of the diaphragm by using at least two vibration modes properly depending on the case.

(Image Pickup Apparatus)

The image pickup apparatus of the present invention includes at least the above-mentioned dust removing device and an image pickup element unit, and the above-mentioned diaphragm of the dust removing device is provided on a light-receiving surface side of the image pickup element unit. With such a configuration, an image pickup apparatus having a dust removing function comparable to or higher than that in the case of using a piezoelectric element containing lead can be provided. Fig. 13 and Fig. 14 are views for illustrating a digital single-lens reflex camera as an example of an exemplary embodiment of the image pickup apparatus of the present invention.

Fig. 13 is a front side perspective view of a camera main body 601 when viewed from an object side, for illustrating a state in which a photographing lens unit is removed. Fig. 14 is an exploded perspective view of a schematic configuration of an inner portion of the camera for illustrating peripheral structures of the dust removing device of the present invention and an image pickup unit 400.

A mirror box 605 that guides a photographing luminous flux having passed through a photographing lens is provided in the camera main body 601, and a main mirror (quick return mirror) 606 is arranged in the mirror box 605. The main mirror 606 may have a state of being held at an angle of 45° with respect to a photographing optical axis in order to guide the photographing luminous flux in a direction of a penta dach mirror (not shown), and a state of being held at a position retracted from the photographing luminous flux in order to guide the photographing luminous flux in a direction of an image pickup element (not shown).

On the object side of a main body chassis 300 serving as a skeleton of the camera main body, the mirror box 605 and a shutter unit 200 are arranged in the stated order from the object side. In addition, the image pickup unit 400 is arranged on a photographer side of the main body chassis 300. The image pickup unit 400 is installed so that an image pickup surface of the image pickup element is adjusted to be parallel to a mounting surface of a mount portion 602 serving as a reference for mounting the photographing lens unit at a predetermined distance.

Herein, the digital single-lens reflex camera has been described as the image pickup apparatus of the present invention, but for example, a camera with an interchangeable photographing lens unit, such as a mirrorless digital single-lens camera without the mirror box 605, may be used. In addition, the image pickup apparatus of the present invention can also be applied to a device in which it is required to remove dust adhering to the surface of an optical component, in particular, among various image pickup apparatus, such as a video camera with an interchangeable photographing lens unit, a copying machine, a fax machine, and a scanner, or an electronic apparatus including an image pickup apparatus. The image pickup unit 400 can be applied as the image pickup element unit of the present invention.

(Ultrasonic Probe)

The ultrasonic probe of the present invention includes the above-mentioned piezoelectric element, and transmits and receives a signal by the piezoelectric element. With such a configuration, an ultrasonic probe having a transmitting/receiving performance comparable to or higher than that of the case of using a piezoelectric element containing lead can be provided.

Fig. 15 is a schematic sectional view for illustrating the ultrasonic probe according to one embodiment of the present invention.

An ultrasonic probe 1100 of Fig. 15 includes a plurality of piezoelectric elements 1101, a backing material 1102, an acoustic matching layer 1103, and an acoustic lens 1104. As illustrated in Fig. 15, the plurality of piezoelectric elements 1101 are arranged on the backing material 1102 so as to adhere thereto, and the acoustic matching layer 1103 that matches an acoustic impedance is formed on each surface serving as a transmitting/receiving surface of the piezoelectric elements 1101 on a side opposite to the backing material 1102.

The acoustic matching layer 1103 may be a single layer or a plurality of layers, preferably two or more layers. As a material to be used for the acoustic matching layer 1103, there may be used, for example, carbon, aluminum, an aluminum alloy (for example, an AL-Mg alloy), a magnesium alloy, Macor glass, glass, fused quartz, copper graphite, polyethylene, polypropylene, polycarbonate, an ABC resin, polyphenylene ether, an ABS resin, an AAS resin, an AES resin, nylon, polyamide imide, polyethylene terephthalate, polycarbonate, an epoxy resin, or a urethane resin.

In addition, as the backing material 1102, there may be used, for example, a thermoplastic resin, such as natural rubber, ferrite rubber, an epoxy resin, vinyl chloride, polyvinyl butyral, an ABS resin, polyurethane, polyvinyl alcohol, polyethylene, polypropylene, polyacetal, polyethylene terephthalate, a fluorine resin, polyethylene glycol, or polyethylene terephthalate, a product obtained by adding metal powder thereto, or a superhard material, such as tungsten carbide.

The piezoelectric element 1101 may be integrated or may be divided into a plurality of pieces. In Fig. 15, there is illustrated an example of a case in which the piezoelectric element 1101 is provided so as to be divided. A flexible cable (not shown) is connected to electrodes of the respective piezoelectric elements so that signals transmitted and received by the piezoelectric elements can be input and output. The acoustic lens 1104 adheres to the acoustic matching layer 1103. The acoustic lens 1104 is a member configured to converge ultrasonic waves transmitted from the piezoelectric elements 1101 toward the object, and has an arc shape in the example of Fig. 15. As a material for the acoustic lens 1104, for example, a rubber containing a silicone-based resin (rubber) as a main component is generally used.

When the ultrasonic probe 1100 is used, an AC voltage is applied to the piezoelectric elements 1101 through the flexible cable, and the piezoelectric elements are vibrated by the piezoelectric effect to transmit the ultrasonic waves from the piezoelectric elements 1101. In this case, when the acoustic impedance of the object which the ultrasonic waves are applied is small, or when the ultrasonic waves are applied to the object through water or air, reflected waves caused by a great change in acoustic impedance can be suppressed due to the presence of the acoustic matching layer 1103, and the ultrasonic waves to the object can be efficiently radiated thereto. Then, at the time of reception, the piezoelectric elements 1101 are vibrated with the ultrasonic waves reflected from the inside of the object, and this vibration is electrically converted by the piezoelectric effect to obtain a reception signal. At the time of transmission and reception, the conversion of electrical energy and mechanical energy is performed, and the conversion efficiency in this case depends on the magnitude of the electromechanical coupling coefficient.

(Ultrasonic Diagnostic Apparatus)

The ultrasonic diagnostic apparatus of the present invention includes at least the above-mentioned ultrasonic probe and an image output unit (also referred to as "image display unit"). With such a configuration, an ultrasonic diagnostic apparatus having driving efficiency comparable to or higher than that in the case of using a piezoelectric element containing lead can be provided. Fig. 16 is a schematic view for illustrating an ultrasonic diagnostic apparatus according to one embodiment of the present invention. The ultrasonic diagnostic apparatus 1110 of Fig. 16 includes an ultrasonic probe 1100, a cable 1111, a drive control unit 1113, an image display unit 1112, and an image processing unit 1114. A flexible cable of the ultrasonic probe 1100 and the drive control unit 1113 are connected by the cable 1111, and an AC voltage is applied from the drive control unit 1113 to a piezoelectric element 1101 of the ultrasonic probe 1100 via the cable 1111. When the ultrasonic waves are radiated to the inside of the object from the ultrasonic probe 1100, the ultrasonic waves reflected from the inside of the object are converted into electric signals again by the ultrasonic probe and input to the image processing unit 1114 through the cable 1111. In the image processing unit 1114, image data is created by calculation from changes in delay time and signal intensity with respect to the AC voltage output from the drive control unit 1113. The created image data is output to the image display unit 1112.

(Ultrasonic Diagnostic System)

The ultrasonic diagnostic system of the present invention includes the above-mentioned ultrasonic probe, a transmission unit that transmits a signal output from the above-mentioned ultrasonic probe, and a reception unit that receives the signal transmitted from the transmission unit. With such a configuration, an ultrasonic diagnostic system having driving efficiency comparable to or higher than that in the case of using a piezoelectric element containing lead can be provided. Fig. 17 and Fig. 18 are schematic views for illustrating an ultrasonic diagnostic system according to one embodiment of the present invention. In the ultrasonic diagnostic system 1120 of Fig. 17, a signal obtained by the ultrasonic probe is transmitted from a transmission unit 1121, and the signal is received by a reception unit 1122. The received signal is used to create image data in an image processing unit 1114, and the image data is output on an image display unit 1112. The distance between the transmission unit 1121 and the reception unit 1122 may be large so that the transmission unit 1121 and the reception unit 1122 are arranged far apart from each other. As means for transmission and reception, wireless communication such as Wi-Fi (trademark) or Bluetooth (trademark) may be used, or communication via a network line obtained by connecting a network cable may be used.

In Fig. 18, the output signal is used to create image data in the image processing unit 1114, the data is transmitted as a signal from the transmission unit 1121, and the signal is received by the reception unit 1122. The received signal is output on the image display unit 1112.

(Electronic Apparatus)

Next, an electronic apparatus of the present invention is described. The electronic apparatus of the present invention includes a piezoelectric acoustic component including the above-mentioned piezoelectric element or the above-mentioned multilayered piezoelectric element. With such a configuration, an electronic apparatus having soundability comparable to or higher than that in the case of using a piezoelectric element containing lead can be provided. The piezoelectric acoustic component includes a speaker, a buzzer, a microphone, and a surface acoustic wave (SAW) element.

Fig. 19 is an overall perspective view of a main body 931 of a digital camera, which is an example of an electronic apparatus according to an exemplary embodiment of the present invention, as viewed from the front. An optical apparatus 901, a microphone 914, a stroboscopic light emission unit 909, and a fill light unit 916 are arranged on a front surface of the main body 931. The microphone 914 is installed in the main body, and hence is indicated by a broken line. A hole shape for collecting external sound is provided in front of the microphone 914.

A power button 933, a speaker 912, a zoom lever 932, and a release button 908 for performing a focus operation are arranged on the top surface of the main body 931. The speaker 912 is installed in the main body 931, and hence is indicated by a broken line. A hole shape for transmitting sound to the outside is provided in front of the speaker 912.

The piezoelectric acoustic component of the present invention is used for at least one of the microphone 914, the speaker 912, or a surface acoustic wave element.

While the digital camera has been described as the electronic apparatus of the present invention, the electronic apparatus of the present invention can also be applied to various types of the electronic apparatus including the piezoelectric acoustic component, such as a sound reproduction device, a sound recording device, a cellular phone, or an information terminal.

As described above, the piezoelectric element of the present invention is suitably used for an ultrasonic motor, an optical apparatus, a vibration device, a dust removing device, an image pickup apparatus, an ultrasonic probe, an ultrasonic diagnostic apparatus, and an electronic apparatus.

The single crystal and the piezoelectric element of the present invention can be used for devices such as a motor, a liquid discharge head, a liquid discharge device, a piezoelectric actuator, a piezoelectric sensor, and a ferroelectric memory, in addition to the above-mentioned devices.

[Examples]

Now, the present invention is described more specifically by way of Examples. However, the present invention is not limited to the following Examples.

The single crystal and the piezoelectric element of the present invention were produced by the method described below.

(Example 1)

As raw material powders, barium titanate ($BaTiO_3$, Ba/Ti=0.999) with an average grain diameter of 100 nm, barium zirconate ($BaZrO_3$, Ba/Zr=1.002), trimanganese tetraoxide ($Mn_3O_4$), and titanium oxide for adjusting the ratio "a" of a sum of numbers of moles of Ti and Zr to a sum of numbers of moles of Ba were used. Those raw material powders were weighed so as to obtain a ratio of composition formula $Ba_{0.985}(Ti_{0.93}, Zr_{0.07})O_3$ containing titanium and barium as main components. Mn was added to 100 parts by mass of the oxide so that content of Mn became 0.12 part by mass in terms of metal. Furthermore, the oxide to which the Mn had been added was mixed by dry mixing for 24 hours through use of a ball mill. In order to granulate the obtained mixed powder, 3 parts by mass of a PVA binder based on the mixed powder was caused to adhere to the surface of the mixed powder through use of a spray dryer device.

Next, the obtained granulated powder was filled in a mold of which a surface on the sample side had been mirror-finished, and a molding pressure of 200 MPa was applied thereto using a press molding machine to produce two rectangular parallelepiped compacts. The compacts may be further pressurized using a cold isostatic molding machine.

Next, one of the above-mentioned compacts was placed as a sample on a heating stage for a microscope (manufactured by Linkam Scientific Instruments Ltd.) and the temperature was increased. Then, the surface of the matrix 1 was observed with a microscope. As a result, the liquid-phase start temperature was 1320°C, and the liquid-phase end temperature was 1385°C.

Next, another one of the compacts was placed in an electric furnace, kept at a maximum temperature of 1300°C for 5 hours, and sintered in an air atmosphere over a total of 24 hours to obtain a rectangular parallelepiped matrix of 12 mm×18 mm×1.3 mm.

Then, the average equivalent circle diameter (in conformity with JIS R1670) and the relative density of the crystal grains forming the obtained matrix 1 were evaluated. As a result, the average equivalent circle diameter was 4 μm, and the relative density was 98%. A polarizing microscope was mainly used for observing the crystal grains. A scanning electron microscope (SEM) was used for identifying the grain diameters of small crystal grains. The average equivalent circle diameter was calculated from this observation result. In addition, the relative density refers to the ratio of the measured density to the theoretical density as described above, and the theoretical density was calculated from the lattice constant obtained by X-ray diffraction and the weighed composition, and the measured density was evaluated using Archimedes method.

Next, the obtained rectangular parallelepiped matrix was polished on both surfaces to a thickness of 1.0 mm while changing the grain size of the abrasive grains, through use of a polisher, and finally, chemical polishing was performed as a finish so as to obtain a mirror surface.

Next, an alumina saggar coated with zirconia as a saggar 7, a zirconia setter as a setter 6, a zirconia setter (size of 50 mm×50 mm×1 mm, and weight of 20 g) as a weight 4, and zirconia beads as beads 5 were prepared, arranged as illustrated in Fig. 3, and placed in an electric furnace under a state of the saggar being covered with a lid 8 as illustrated in Fig. 4, to be heated.

The seed single crystal 2 used in this case was a $BaTiO_3$ (manufactured by Physcience Opto-electronics) substrate of 10 mm×10 mm×1 mm, in which both the main surface and the side surface were (100) planes, and both surfaces had been mirror-polished.

As shown in Fig. 5, the temperature increase profile during heating was such that, as a first temperature-increasing step 51, the temperature was increased from room temperature to the liquid-phase start temperature of 1320°C over 8.8 hours at a rate of temperature increase of 150°C/h, and then, as a second temperature-increasing step 52, the temperature was increased from 1320°C to the liquid-phase end temperature of 1385°C over 100 hours at a rate of temperature increase of 0.65°C/h. After that, as a heating step, the temperature was kept at 1385°C for 300 h, and finally, the temperature was decreased to room temperature by natural cooling. The first temperature-increasing step 51, the second temperature-increasing step 52, and the heating step were performed in the air.

Fig. 20 shows the matrix 1 after heating, and it can be seen that a single crystal grown portion 3 has spread from the seed single crystal 2. When the matrix after heating was observed with an optical microscope, it was confirmed that the single crystal grown portion 3 (the region spread from the seed single crystal) was a single crystal with no grain boundaries.

Next, the portion of the seed single crystal 2 was removed by polishing, and the single crystal portion was cut out with a dicing saw to obtain a single crystal. The longest part of the obtained single crystal was 17 mm.

Next, the crystal structure of the polished single crystal was analyzed by X-ray diffraction. As a result, only a peak corresponding to a (100)-oriented single crystal of a perovskite type was observed. In addition, when the relative density of the obtained single crystal was measured, the relative density was 97%.

Next, the composition of the obtained single crystal was evaluated by ICP emission spectrometry. The results are shown in Table 1 (Table 1-1 and Table 1-2). As a result, the composition of Ba, Ti, Zr, and Mn after heating was matched with the weighed composition of Ba, Ti, Zr, and Mn.

Next, gold electrodes each having a thickness of 400 nm were formed on both main surfaces of the single crystal by a DC sputtering method. Titanium was formed into a film having a thickness of 30 nm as a contact layer between each of the electrodes and the single crystal.

The single crystal with electrodes was cut into a size of 10 mm×2.5 mm×0.5 mm so that the 45° direction was the long side, in other words, the (100) plane was the upper and lower surfaces and the (110) plane was the side surface, to produce a strip-shaped piezoelectric element of the present invention. The obtained piezoelectric element was subjected to polarization treatment by setting the surface of a hot plate from 60°C to 100°C to apply an electric field of 1 kV/mm for 30 minutes on the hot plate.

Next, as static characteristics of the piezoelectric element including the single crystal of the present invention, the piezoelectric constant $d_{31}$ and the mechanical quality factor Qm of the piezoelectric element subjected to the polarization treatment were evaluated by a resonance-antiresonance method at room temperature (25°C) with an impedance analyzer (4294A manufactured by Agilent Technologies). The results are shown in Table 2. The resonance-antiresonance method is a method in which measurement results of a resonance frequency and an antiresonance frequency obtained through use of an impedance analyzer are used to perform calculation based on the Japan Electronics and Information Technology Industries Association standards (JEITA EM-4501) to obtain values.

Next, the coercive electric field of the piezoelectric element was evaluated. Through use of a ferroelectric/piezoelectric evaluation system (LC II manufactured by Radiant Technologies, Inc.), the electric field when polarization amount is 0 was read from a PE hysteresis curve obtained from the polarization amount with respect to the electric field, and this value was defined as the coercive electric field. The coercive electric field was 1.6 kV/cm.

Next, the power consumption of the strip-shaped piezoelectric element was evaluated. The power consumption was measured with a power meter as the value of power consumption obtained when an AC voltage was applied to change the magnitude and frequency of the AC voltage so that the displacement amount became 1.0 μm. The displacement amount was measured by a Laser Doppler vibrometer. The power consumption was 16 mW.

(Example 2)

As shown in Table 1, a single crystal and a piezoelectric element of the present invention were obtained by the same process as in Example 1, except that a compact was used as the matrix 1.

Subsequently, the composition, the longest part, the relative density, the piezoelectric constant $d_{31}$, the mechanical quality factor Qm, and the power consumption of the single crystal of the present invention were evaluated by the same process as in Example 1. The results are shown in Table 1 and Table 2.

(Example 3)

As shown in Table 1, a single crystal and a piezoelectric element of the present invention were obtained by the same process as in Example 1, except that a compact was used as the matrix 1 and $(Ba_{0.78}Ca_{0.22})TiO_3$ was used as the seed single crystal 2.

As the seed single crystal 2, $(Ba_{0.78}Ca_{0.22})TiO_3$ produced by a floating zone method was used.

Subsequently, the composition, the longest part, the relative density, the piezoelectric constant $d_{31}$, the mechanical quality factor Qm, and the power consumption of the single crystal of the present invention were evaluated by the same process as in Example 1. The results are shown in Table 1 and Table 2.

(Example 4)

As shown in Table 1, a single crystal and a piezoelectric element of the present invention were obtained by the same process as in Example 1, except that a compact was used as the matrix 1 and $Ba_{0.990}(Ti_{0.93}Zr_{0.07})O_3$ was used as the seed single crystal 2.

The $Ba_{0.990}(Ti_{0.93}Zr_{0.07})O_3$ of the seed single crystal 2 was produced by the same process as in Example 1, and was obtained by cutting out the single crystal portion spread from the seed single crystal portion. This single crystal was used as a seed single crystal in this case.

Subsequently, the composition, the longest part, the relative density, the piezoelectric constant $d_{31}$, the mechanical quality factor Qm, and the power consumption of the single crystal of the present invention were evaluated by the same process as in Example 1. The results are shown in Table 1 and Table 2.

(Examples 5 and 6)

As shown in Table 1, a single crystal and a piezoelectric element of the present invention were obtained by the same process as in Example 1, except that a compact was used as the matrix 1 and the first rate of temperature increase or the second rate of temperature increase was changed.

Subsequently, the composition, the longest part, the relative density, piezoelectric constant $d_{31}$, the mechanical quality factor Qm, and the power consumption of the single crystal of the present invention were evaluated by the same process as in Example 1. The results are shown in Table 1 and Table 2.

(Examples 7 to 12)

As shown in Table 1, a single crystal and a piezoelectric element of the present invention were obtained by the same process as in Example 1, except that a compact was used as the matrix 1 and the amounts of addition of barium titanate, barium zirconate, trimanganese tetraoxide, and titanium oxide were changed.

Subsequently, the composition, the longest part, the relative density, piezoelectric constant $d_{31}$, the mechanical quality factor Qm, and the power consumption of the single crystal of the present invention were evaluated by the same process as in Example 1. The results are shown in Table 1 and Table 2.

(Examples 13 to 17)

As shown in Table 1, a single crystal and a piezoelectric element of the present invention were obtained by the same process as in Example 1, except that a compact was used as the matrix 1, amounts of addition of barium titanate, barium zirconate, trimanganese tetraoxide, and titanium oxide were changed, and bismuth trioxide was added.

Subsequently, the composition, the longest part, the relative density, the piezoelectric constant $d_{31}$, the mechanical quality factor Qm, and the power consumption of the single crystal of the present invention were evaluated by the same process as in Example 1. The results are shown in Table 1 and Table 2.

(Comparative Example 1)

As raw material powders, barium titanate ($BaTiO_3$, Ba/Ti=0.999) with an average grain diameter of 100 nm, barium zirconate ($BaZrO_3$, Ba/Zr=1.002), trimanganese tetraoxide ($Mn_3O_4$), and titanium oxide for adjusting the ratio "a" of the sum of the numbers of moles of Ti and Zr to the sum of the numbers of moles of Ba were used. Those raw material powders were weighed so as to obtain a ratio of the composition formula $Ba_{0.985}(Ti_{0.93}, Zr_{0.07})O_3$ containing titanium and barium as main components. Mn was added to 100 parts by mass of the metal oxide so that the content of Mn became 0.12 part by mass in terms of metal. Furthermore, the oxide to which the Mn had been added was mixed by dry mixing for 24 hours through use of a ball mill. In order to granulate the obtained mixed powder, 3 parts by mass of a PVA binder based on the mixed powder was caused to adhere to the surface of the mixed powder through used of a spray dryer device.

Next, the obtained granulated powder was filled in a mold of which a surface on the sample side had been mirror-finished, and a molding pressure of 200 MPa was applied thereto using a press molding machine to produce two rectangular parallelepiped compacts. The compacts may be further pressurized using a cold isostatic molding machine.

Next, one of the above-mentioned compacts was placed as a sample on a heating stage for a microscope (manufactured by Linkam Scientific Instruments Ltd.) and the temperature was increased. A surface of the matrix 1 was observed with a microscope. As a result, the liquid-phase start temperature was 1320°C, and the liquid-phase end temperature was 1385°C.

Next, another one of the compacts was placed in an electric furnace, kept at a maximum temperature of 1300°C for 5 hours, and sintered in an air atmosphere over a total of 24 hours to obtain a rectangular parallelepiped matrix 1 of 12 mm×18 mm×1.3 mm.

Then, the average equivalent circle diameter and the relative density of the crystal grains forming the obtained matrix 1 were evaluated. As a result, the average equivalent circle diameter was 4 μm, and the relative density was 98%. A polarizing microscope was mainly used for observing the crystal grains. A scanning electron microscope (SEM) was used for identifying the grain diameter of small crystal grains. The average equivalent circle diameter was calculated from this observation result. In addition, the relative density was evaluated through used of the theoretical density calculated from the lattice constant obtained by X-ray diffraction and the weighed composition, and the measured density by the Archimedes method.

Next, the obtained rectangular parallelepiped matrix 1 was polished on both surfaces to a thickness of 1.0 mm while changing the grain size of the abrasive grains, through use of a polisher, and finally, chemical polishing was performed as a finish so as to obtain a mirror surface.

Next, an alumina saggar coated with zirconia as a saggar 7, a zirconia setter as a setter 6, a zirconia setter (size of 50 mm×50 mm×1 mm, and weight of 20 g) as a weight 4, and zirconia beads as beads 5 were prepared, arranged as illustrated in Fig. 3, and placed in an electric furnace under a state of the saggar being covered with a lid as illustrated in Fig. 4, to be heated.

The seed single crystal 2 used in this case was a $BaTiO_3$ (manufactured by Physcience Opto-electronics) substrate of 10 mm×10 mm×1 mm, in which both upper and lower surfaces and side surfaces were (100) planes, and both surfaces had been mirror-polished.

The temperature increase profile during heating was such that the temperature was increased from room temperature to the liquid-phase start temperature of 1320°C over 8.8 hours at a rate of temperature increase of 150°C/h, and then the temperature was increased from 1320°C to the liquid-phase end temperature of 1385°C at the same rate of temperature increase of 150°C/h. After that, the temperature was kept at 1385°C for 300 h, and finally, the temperature was decreased to room temperature by natural cooling.

In the matrix after heating, no region in which a single crystal portion spread from the seed single crystal was observed, and hence a single crystal could not be obtained.

(Comparative Example 2)

As shown in Table 1, the same process as in Comparative Example 1 was performed, except that the first rate of temperature increase and the second rate of temperature increase were changed.

In the matrix 1 after heating, no region in which a single crystal portion spread from the seed single crystal was observed, and hence a single crystal could not be obtained.

(Comparative Example 3)

As shown in Table 1, the same process as in Comparative Example 1 was performed, except that the amounts of addition of barium titanate, barium zirconate, trimanganese tetraoxide, and titanium oxide were changed, and bismuth trioxide was added.

In the matrix 1 after heating, no region in which a single crystal portion spread from the seed single crystal was observed, and hence a single crystal could not be obtained.

(Comparative Example 4)

As raw material powders, barium titanate ($BaTiO_3$, Ba/Ti=0.999) with an average grain diameter of 100 nm, barium zirconate ($BaZrO_3$, Ba/Zr=1.002), and titanium oxide for adjusting the ratio "a" of the sum of the numbers of moles of Ti and Zr to the sum of the numbers of moles of Ba were used. Those raw material powders were weighed so as to obtain a ratio of the composition formula $Ba_{0.985}(Ti_{0.93}, Zr_{0.07})O_3$ containing titanium and barium as main components. Those powders were mixed by dry mixing for 24 hours through use of a ball mill. In order to granulate the obtained mixed powder, 3 parts by mass of a PVA binder of the mixed powder was caused to adhere to the surface of the mixed powder through use of a spray dryer device.

Next, the obtained granulated powder was filled in a mold of which a surface on the sample side had been mirror-finished, and a molding pressure of 200 MPa was applied thereto using a press molding machine to produce a rectangular parallelepiped compact. This compact may be further pressurized using a cold isostatic molding machine.

Next, the compact was placed in an electric furnace, kept at a maximum temperature of 1300°C for 5 hours, and sintered in an air atmosphere over a total of 24 hours to obtain a rectangular parallelepiped sintered compact of 12 mm×18 mm×1.3 mm.

Next, the obtained rectangular parallelepiped sintered compact was polished on both surfaces to a thickness of 1.0 mm while changing the grain size of the abrasive grains, through use of a polisher, and finally, chemical polishing was performed as a finish so as to obtain a mirror surface.

Next, an alumina saggar coated with zirconia as a saggar 7, a zirconia setter as a setter 6, a zirconia setter (size of 50 mm×50 mm×1 mm, and weight of 20 g) as a weight 4, and zirconia beads as beads 5 were prepared, arranged as illustrated in Fig. 3, and placed in an electric furnace under a state of the saggar being covered with a lid as illustrated in Fig. 4, to be heated.

The seed single crystal 2 used in this case was a $BaTiO_3$ (manufactured by Physcience Opto-electronics) substrate of 10 mm×10 mm×1 mm, in which both the main surface and the side surface were (100) planes, and both surfaces had been mirror-polished.

The temperature increase profile during heating was such that the temperature was increased from room temperature to the liquid-phase start temperature of 1320°C over 8.8 hours at a rate of temperature increase of 150°C/h, and then the temperature was increased from 1320°C to the liquid-phase end temperature of 1385°C at a same rate of temperature increase of 150°C/h. After that, the temperature was kept at 1385°C for 300 h, and finally, the temperature was decreased to room temperature by natural cooling.

In the matrix 1 after heating, a single crystal grown portion 3 spread from the seed single crystal, and when the matrix 1 after heating was observed with an optical microscope, it was confirmed that the single crystal grown portion 3 (the region spread from the seed single crystal) was a single crystal with no grain boundaries.

Next, the portion of the seed single crystal was removed by polishing, and the single crystal portion was cut out with a dicing saw to obtain a single crystal of Comparative Example 4.

Next, the crystal structure of the polished single crystal was analyzed by X-ray diffraction. As a result, only a peak corresponding to a (100)-oriented single crystal of a perovskite type was observed.

In addition, when the relative density of the obtained single crystal was measured, the relative density was 97%. The longest part of the obtained single crystal was 15 mm.

Next, the composition of the obtained single crystal was evaluated by ICP emission spectrometry. As a result, the composition of Ba, Ti, and Zr after heating was matched with the weighed composition of Ba, Ti, and Zr.

Next, gold electrodes each having a thickness of 400 nm were formed on the front and back surfaces of the single crystal by a DC sputtering method. Titanium was formed into a film having a thickness of 30 nm as a contact layer between each of the electrodes and the single crystal.

The single crystal with electrodes was cut into a size of 10 mm×2.5 mm×0.5 mm so that the 45° direction was the long side, in other words, the (100) plane was the upper and lower surfaces and the (110) plane was the side surface, to produce a strip-shaped piezoelectric element of Comparative Example 4. The obtained piezoelectric element was subjected to polarization treatment by setting the surface of a hot plate from 60°C to 100°C to apply an electric field of 1 kV/mm for 30 minutes on the hot plate.

Next, as static characteristics of the piezoelectric element having the single crystal of Comparative Example 4, the piezoelectric constant $d_{31}$ and the mechanical quality factor Qm of the piezoelectric element subjected to the polarization treatment were evaluated by a resonance-antiresonance method at room temperature (25°C) with an impedance analyzer (4294A manufactured by Agilent Technologies). The results are shown in Table 2.

Next, the coercive electric field of the piezoelectric element was evaluated. Through use of a ferroelectric/piezoelectric evaluation system (LC II manufactured by Radiant Technologies, Inc.), the electric field at the time of polarization amount of 0 was read from a PE hysteresis curve obtained from the polarization amount with respect to the electric field, and this value was defined as the coercive electric field. The coercive electric field at this time was 0.8 kV/cm.

Next, the power consumption of the strip-shaped piezoelectric element was evaluated. The power consumption was measured with a power meter as the value of power consumption obtained when an AC voltage was applied to change the magnitude and frequency of the AC voltage so that the displacement amount became 1.0 μm. At this time, the displacement amount was measured by a Laser Doppler vibrometer. The power consumption at this time was 31 mW.

In Table 1 below, when a single crystal was obtained as a result of implementing Examples and Comparative Examples, A was described in the column of "Whether single crystal or not", and when a single crystal was not obtained, B was described in the column of "Whether single crystal or not".

[Table 1]

| Table 1-1 | | | | | | | |
|---|---|---|---|---|---|---|---|
| | Composition of single crystal | Whether single crystal or not | Liquid-phase start temperature (°C) | Liquid-phase end temperature (°C) | Rate of temperature increase in first temperature-increasing step (°C/h) | Time for temperature increase in first temperature-increasing step (h) |
| Example 1 | $Ba_{0.985}(Ti_{0.93}Zr_{0.07})O_3$ +Mn 0.12 mass% | A | 1,320 | 1,385 | 150 | 8.8 |
| Example 2 | $Ba_{0.985}(Ti_{0.93}Zr_{0.07})O_3$ +Mn 0.12 mass% | A | 1,320 | 1,385 | 150 | 8.8 |
| Example 3 | $Ba_{0.985}(Ti_{0.93}Zr_{0.07})O_3$ +Mn 0.12 mass% | A | 1,320 | 1,385 | 150 | 8.8 |
| Example 4 | $Ba_{0.985}(Ti_{0.93}Zr_{0.07})O_3$ +Mn 0.12 mass% | A | 1,320 | 1,385 | 150 | 8.8 |
| Example 5 | $Ba_{0.985}(Ti_{0.93}Zr_{0.07})O_3$ +Mn 0.12 mass% | A | 1,320 | 1,385 | 100 | 13.2 |

(continued)

| Table 1-1 | | | | | | |
|---|---|---|---|---|---|---|
| | Composition of single crystal | Whether single crystal or not | Liquid-phase start temperature (°C) | Liquid-phase end temperature (°C) | Rate of temperature increase in first temperature-increasing step (°C/h) | Time for temperature increase in first temperature-increasing step (h) |
| Example 6 | $Ba_{0.985}(Ti_{0.93}Zr_{0.07})O_3$ +Mn 0.12 mass% | A | 1,320 | 1,385 | 150 | 8.8 |
| Example 7 | $Ba_{0.965}(Ti_{0.93}Zr_{0.07})O_3$ +Mn 0.12 mass% | A | 1,300 | 1,370 | 150 | 8.7 |
| Example 8 | $Ba_{1.020}(Ti_{0.93}Zr_{0.07})O_3$ +Mn 0.12 mass% | A | 1,280 | 1,340 | 150 | 8.5 |
| Example 9 | $Ba_{0.985}(Ti_{0.93}Zr_{0.07})O_3$ +Mn 0.04 mass% | A | 1,318 | 1,385 | 150 | 8.8 |
| Example 10 | $Ba_{0.985}(Ti_{0.93}Zr_{0.07})O_3$ +Mn 0.36 mass% | A | 1,322 | 1,385 | 150 | 8.8 |
| Example 11 | $Ba_{0.985}(Ti0_{.95}Zr_{0.05})O_3$ +Mn 0.12 mass% | A | 1,320 | 1,390 | 150 | 8.8 |
| Example 12 | $Ba_{0.985}(Ti_{0.90}Zr_{0.10})O_3$ +Mn 0.12 mass% | A | 1,320 | 1,380 | 150 | 8.8 |
| Example 13 | $(Ba)_{0.985}(Ti_{0.98}Zr_{0.02})O_3$ +Mn 0.23 mass%+Bi 0.08 mass% | A | 1,320 | 1,400 | 150 | 8.8 |
| Example 14 | $(Ba)_{0.980}(Ti_{0.99}Zr_{0.01})O_3$ +Mn 0.23 mass%+Bi 0.04 mass% | A | 1,320 | 1,400 | 150 | 8.8 |
| Example 15 | $(Ba)_{0.980}(Ti_{0.98}Zr_{0.02})O_3$ +Mn 0.04 mass%+Bi 0.08 mass% | A | 1,320 | 1,400 | 150 | 8.8 |
| Example 16 | $(Ba)_{0.980}(Ti_{0.97}Zr_{0.03})O_3$ +Mn 1.16 mass%+Bi 0.08 mass% | A | 1,320 | 1,400 | 150 | 8.8 |
| Example 17 | $(Ba)_{1.020}(Ti_{0.99}Zr_{0.01})O_3$ +Mn 0.23 mass%+Bi 0.53 mass% | A | 1,320 | 1,400 | 150 | 8.8 |
| Comparative Example 1 | $Ba_{1.002}(Ti_{0.93}Zr_{0.07})O_3$ +Mn 0.12 mass% | B | 1,320 | 1,385 | 150 | 8.8 |
| Comparative Example 2 | $Ba_{1.002}(Ti_{0.93}Zr_{0.07})O_3$ +Mn 0.12 mass% | B | 1,320 | 1,385 | 60 | 22.0 |
| Comparative Example 3 | $(Ba)_{0.985}(Ti_{0.98}Zr_{0.02})O_3$ +Mn 0.23 mass%+Bi 0.08 mass% | B | 1,320 | 1,400 | 150 | 8.8 |
| Comparative Example 4 | $Ba_{0.985}(Ti_{0.93}Zr_{0.07})O_3$ | A | - | - | 150 | - |

Table 1-2

| | Rate of temperature increase in second temperature-increasing step (°C/h) | Time for temperature increase in second temperature-increasing step (h) | Matrix | Seed single crystal |
|---|---|---|---|---|
| Example 1 | 0.65 | 100 | Sintered compact | $BaTiO_3$ |
| Example 2 | 0.65 | 100 | Compact | $BaTiO_3$ |
| Example 3 | 0.65 | 100 | Compact | $(0.78Ba0.22Ca) TiO_3$ |
| Example 4 | 0.65 | 100 | Compact | $Ba_{0.990} (Ti_{0.93}Zr_{0.07}) O3$ |
| Example 5 | 0.65 | 100 | Compact | $BaTiO_3$ |
| Example 6 | 1 | 65 | Compact | $BaTiO_3$ |
| Example 7 | 0.65 | 108 | Compact | $BaTiO_3$ |
| Example 8 | 0.65 | 92 | Compact | $BaTiO_3$ |
| Example 9 | 0.65 | 103 | Compact | $BaTiO_3$ |
| Example 10 | 0.65 | 97 | Compact | $BaTiO_3$ |
| Example 11 | 0.87 | 80 | Compact | $BaTiO_3$ |
| Example 12 | 0.65 | 92 | Compact | $BaTiO_3$ |
| Example 13 | 0.65 | 123 | Compact | $BaTiO_3$ |
| Example 14 | 0.65 | 123 | Compact | $BaTiO_3$ |
| Example 15 | 0.65 | 123 | Compact | $BaTiO_3$ |
| Example 16 | 0.65 | 123 | Compact | $BaTiO_3$ |
| Example 17 | 0.65 | 123 | Compact | $BaTiO_3$ |
| Comparative Example 1 | 150 | 0.4 | Sintered compact | $BaTiO_3$ |
| Comparative Example 2 | 60 | 1.1 | Sintered compact | $BaTiO_3$ |
| Comparative Example 3 | 150 | 0.5 | Sintered compact | $BaTiO_3$ |
| Comparative Example 4 | 150 | - | Sintered compact | $BaTiO_3$ |

[Table 2]

Table 2

| | Longest part (mm) | Relative density of single crystal (%) | Piezoelectric constant $d_{31}$ (pm/V) | Qm | Coercive electric field (kV/cm) | Power consumption (mW) |
|---|---|---|---|---|---|---|
| Example 1 | 17 | 97 | 484 | 750 | 1.6 | 16 |
| Example 2 | 17 | 98 | 475 | 749 | 1.6 | 16 |
| Example 3 | 17 | 98 | 485 | 753 | 1.6 | 15 |
| Example 4 | 17 | 99 | 489 | 759 | 1.6 | 14 |
| Example 5 | 17 | 98 | 477 | 752 | 1.6 | 16 |
| Example 6 | 17 | 98 | 465 | 745 | 1.6 | 16 |

(continued)

| | Longest part (mm) | Relative density of single crystal (%) | Piezoelectric constant $d_{31}$ (pm/V) | Qm | Coercive electric field (kV/cm) | Power consumption (mW) |
|---|---|---|---|---|---|---|
| Example 7 | 20 | 97 | 450 | 750 | 1.6 | 16 |
| Example 8 | 13 | 99 | 490 | 761 | 1.6 | 14 |
| Example 9 | 20 | 97 | 477 | 500 | 1.4 | 16 |
| Example 10 | 10 | 97 | 450 | 790 | 2.5 | 16 |
| Example 11 | 13 | 97 | 410 | 515 | 2.2 | 16 |
| Example 12 | 12 | 97 | 460 | 744 | 2.0 | 16 |
| Example 13 | 10 | 97 | 400 | 805 | 4.2 | 16 |
| Example 14 | 11 | 97 | 390 | 795 | 4.1 | 16 |
| Example 15 | 10 | 97 | 403 | 803 | 4.0 | 15 |
| Example 16 | 10 | 97 | 407 | 815 | 4.4 | 16 |
| Example 17 | 11 | 97 | 400 | 817 | 4.4 | 16 |
| Comparative Example 1 | - | - | - | - | - | - |
| Comparative Example 2 | - | - | - | - | - | - |
| Comparative Example 3 | - | - | - | - | - | - |
| Comparative Example 4 | 15 | 97 | 440 | 120 | 0.8 | 31 |

(Example 18)

An ultrasonic motor illustrated in Fig. 7 was produced through use of the piezoelectric element of Example 4. In the produced ultrasonic motor, rotation of the motor in response to the application of an AC voltage was confirmed.

(Example 19)

An optical apparatus illustrated in Fig. 9 was produced through use of the ultrasonic motor of Example 13. In the produced optical apparatus, an autofocus operation in response to the application of an AC voltage was recognized.

(Example 20)

A dust removing device illustrated in Fig. 10A and Fig. 10B was produced through use of the piezoelectric element of Example 4. In the produced dust removing device, when plastic beads were sprayed and an AC voltage was applied, a satisfactory dust removing rate was recognized.

(Example 21)

An image pickup apparatus illustrated in Fig. 13 was produced through use of the dust removing device of Example 15. When the produced image pickup apparatus was operated, dust on the surface of the image pickup unit was satisfactorily removed, and an image without dust defects was obtained.

(Example 22)

The ultrasonic probe illustrated in Fig. 15 was produced through use of the piezoelectric element of Example 4. In the produced ultrasonic probe, ultrasonic waves were transmitted by the application of an AC voltage, and a reception signal caused by reflection from the inside of an object was recognized.

## EP 4 696 821 A1

(Example 23)

The ultrasonic diagnostic apparatus illustrated in Fig. 16 was produced through use of the ultrasonic probe of Example 17. When the produced ultrasonic diagnostic apparatus was operated, an image of the inside of an object was clearly output.

(Example 24)

An ultrasonic diagnostic system illustrated in Fig. 17 was produced through use of the ultrasonic probe of Example 17. When the produced ultrasonic diagnostic system was operated and an image was displayed on an image display unit, an image of the inside of an object was clearly output.

(Example 25)

An electronic apparatus illustrated in Fig. 19 was produced through use of the piezoelectric element of Example 4. In the produced electronic apparatus, a speaker operation in response to the application of an AC voltage was recognized.

[Industrial Applicability]

The method of producing a single crystal of the present invention can be applied to a wide range of material compositions, and the single crystal of the present invention has a large piezoelectric constant and a large mechanical quality factor. Accordingly, the single crystal of the present invention can be used without problems in many devices such as an ultrasonic motor, a dust removing device, and an ultrasonic probe.

The present invention is not limited to the embodiments described above, and various changes and modifications can be made without departing from the spirit and scope of the present invention. The following claims are appended hereto in order to make the scope of the present invention public.

The present application claims priority based on Japanese Patent Application No. 2023-066551 filed April 14, 2023, and Japanese Patent Application No. 2024-045263 filed March 21, 2024, and the entire contents thereof are incorporated herein by reference.

[Reference Signs List]

1 matrix
2 seed single crystal
3 single crystal
4 weight
5 bead
6 setter
7 saggar
8 lid
11 first electrode
22 single crystal portion
33 second electrode
51 first temperature-increasing step
52 second temperature-increasing step
201 vibrator
202 rotor
203 output shaft
2011 elastic ring
2012 piezoelectric element
2013 organic adhesive
310 dust removing device
320 diaphragm
330 piezoelectric element
331 single crystal

332 first electrode
333 second electrode
336 first electrode surface
337 second electrode surface
601 camera main body
602 mount portion
605 mirror box
606 main mirror
200 shutter unit
300 main body chassis
400 image pickup unit
701 front group lens
702 rear group lens (focus lens)
711 attaching/detaching mount
712 fixed barrel
713 linear guide barrel
714 front unit barrel
715 cam ring
716 rear unit barrel
717 cam roller
718 axial screw
719 roller
720 rotation transmission ring
722 roller
724 manual focus ring
725 ultrasonic motor
726 waved washer
727 ball race
728 focus key
729 joining member
732 washer
733 low friction sheet
901 optical apparatus
908 release button
909 stroboscopic light emission unit
912 speaker
914 microphone
916 fill light unit
931 main body
932 zoom lever
933 power button
1100 ultrasonic probe
1101 piezoelectric element
1102 backing layer
1103 acoustic matching layer
1104 acoustic lens
1110 ultrasonic diagnostic apparatus
1111 cable
1112 image display unit
1113 drive control unit
1114 image processing unit
1120 ultrasonic diagnostic system
1121 transmission unit
1122 reception unit

**Claims**

1. A method of producing a single crystal by heating a matrix, the method comprising:

    a first preparation step of preparing a matrix and a seed single crystal;
    a second preparation step of preparing an integrated body in which a surface of the matrix and a surface of the seed single crystal are arranged in contact with each other;
    a first temperature-increasing step of increasing a temperature of the integrated body from room temperature to a liquid-phase start temperature of the matrix;
    a second temperature-increasing step of increasing the temperature of the integrated body from the liquid-phase start temperature to a liquid-phase end temperature of the matrix;
    a heating step of heating the integrated body at the liquid-phase end temperature; and
    a step of obtaining a single crystal from the integrated body after the heating,
    wherein a rate of temperature increase in the second temperature-increasing step is lower than a rate of temperature increase in the first temperature-increasing step.

2. The method of producing a single crystal according to claim 1, wherein the single crystal includes Ba, Ti, Zr, and Mn.

3. The method of producing a single crystal according to claim 1 or 2,

    wherein the single crystal includes a perovskite-type oxide containing Ba, Ti, and Zr, and Mn,
    wherein "x", which represents a molar ratio of the Zr to a sum of the Ti and the Zr, satisfies $0.01 \leq x \leq 0.13$, and
    wherein a content of the Mn is 0.04 part by mass or more and 1.16 parts by mass or less in terms of metal with respect to 100 parts by mass of the oxide.

4. The method of producing a single crystal according to any one of claims 1 to 3,

    wherein the single crystal includes a perovskite-type oxide containing Ba, Ti, and Zr,
    wherein "x", which represents a molar ratio of the Zr to a sum of the Ti and the Zr, satisfies $0.01 \leq x \leq 0.03$,
    wherein "a", which represents a molar ratio of the Ba to the sum of the Ti and the Zr, satisfies $0.976 \leq a \leq 1.020$,
    wherein the single crystal contains Mn and Bi,
    wherein a content of the Mn is 0.04 part by mass or more and 1.16 parts by mass or less in terms of metal with respect to 100 parts by mass of the oxide, and
    wherein a content of the Bi is 0.04 part by mass or more and 0.53 part by mass or less in terms of metal with respect to 100 parts by mass of the oxide.

5. The method of producing a single crystal according to any one of claims 1 to 4, wherein the seed single crystal has Ba, Ti, and Zr as main components.

6. The method of producing a single crystal according to any one of claims 1 to 4, wherein the seed single crystal has Ba, Ti, and Ca as main components.

7. The method of producing a single crystal according to any one of claims 1 to 6, wherein the matrix is a compact.

8. The method of producing a single crystal according to any one of claims 1 to 7, wherein a relative density of the matrix is 93% or more and 100% or less.

9. The method of producing a single crystal according to any one of claims 1 to 8, wherein the matrix is a polycrystal containing an element forming the single crystal.

10. The method of producing a single crystal according to any one of claims 1 to 9, wherein a rate of temperature increase in the second temperature-increasing step is 1°C or less per hour on a time average.

11. A single crystal comprising a perovskite-type oxide containing Ba, Ti, and Zr, and Mn,

    wherein "x", which represents a molar ratio of the Zr to a sum of the Ti and the Zr, satisfies $0.01 \leq x \leq 0.13$, and
    wherein a content of the Mn is 0.04 part by mass or more and 1.16 parts by mass or less in terms of metal with respect to 100 parts by mass of the oxide.

12. The single crystal according to claim 11,

   wherein "x", which represents a molar ratio of the Zr to a sum of the Ti and the Zr, satisfies $0.01 \leq x \leq 0.03$,
   wherein "a", which represents a molar ratio of Ba to the sum of the Ti and the Zr, satisfies $0.976 \leq a \leq 1.020$,
   wherein the single crystal further comprises Bi, and
   wherein a content of the Bi is 0.04 part by mass or more and 0.53 part by mass or less in terms of metal with respect to 100 parts by mass of the oxide.

13. The single crystal according to claim 11 or 12, wherein a longest part is 1 mm or more and 100 mm or less.

14. The single crystal according to any one of claims 11 to 13, wherein a relative density is 93% or more and 100% or less.

15. The single crystal according to any one of claims 11 to 14, wherein a mechanical quality factor Qm is 500 or more.

16. A piezoelectric element comprising:

   a plurality of electrodes; and
   the single crystal of any one of claims 11 to 15.

17. An ultrasonic motor comprising:

   a vibrating body including the piezoelectric element of claim 16, and
   a moving body configured to be brought into contact with the vibrating body.

18. An optical apparatus comprising a drive unit including the ultrasonic motor of claim 17.

19. A vibration device comprising a vibrating body including a diaphragm including the piezoelectric element of claim 16.

20. A dust removing device comprising a vibration unit including the vibration device of claim 19.

21. An image pickup apparatus comprising:

   the dust removing device of claim 20; and
   an image pickup element unit,
   wherein a diaphragm of the dust removing device is provided on a light-receiving surface side of the image pickup element unit.

22. An ultrasonic probe comprising the piezoelectric element of claim 16, the ultrasonic probe being configured to transmit and receive a signal by the piezoelectric element.

23. An ultrasonic diagnostic apparatus comprising:

   the ultrasonic probe of claim 22; and
   an image output unit.

24. An ultrasonic diagnostic system comprising:

   the ultrasonic probe of claim 22;
   a transmission unit configured to transmit a signal output from the ultrasonic probe; and
   a reception unit configured to receive the signal transmitted from the transmission unit.

25. An electronic apparatus comprising a piezoelectric acoustic component including the piezoelectric element of claim 16.

## FIG. 1

## FIG. 2

## FIG. 3

## FIG. 4

## FIG. 5

## FIG. 6

## FIG. 7

## FIG. 8A

## FIG. 8B

## FIG. 9

## FIG. 10A

## FIG. 10B

## FIG. 11A

330

332
331
333

## FIG. 11B

330

332
331
333
337
336

## FIG. 11C

330

332

## FIG. 12A

## FIG. 12B

# FIG. 13

# FIG. 14

# FIG. 15

1100
1102
1101
1103
1104

# FIG. 16

1110

1112
1111
1113
1100
1114

# FIG. 17

# FIG. 18

## FIG. 19

## FIG. 20

## INTERNATIONAL SEARCH REPORT

| International application No. |
|---|
| **PCT/JP2024/014677** |

### A. CLASSIFICATION OF SUBJECT MATTER

*C30B 29/32*(2006.01)i; *C04B 35/468*(2006.01)i; *H10N 30/20*(2023.01)i; *H10N 30/30*(2023.01)i; *H10N 30/057*(2023.01)i; *H10N 30/077*(2023.01)i; *H10N 30/079*(2023.01)i; *H10N 30/88*(2023.01)i; *H10N 30/097*(2023.01)i; *H10N 30/853*(2023.01)i
FI:  C30B29/32; H10N30/853; H10N30/079; H10N30/20; H10N30/30; H10N30/88; H10N30/097; H10N30/057; C04B35/468 200; H10N30/077

According to International Patent Classification (IPC) or to both national classification and IPC

### B. FIELDS SEARCHED

Minimum documentation searched (classification system followed by classification symbols)

C30B29/32; C04B35/468; H10N30/20; H10N30/30; H10N30/057; H10N30/077; H10N30/079; H10N30/88; H10N30/097; H10N30/853

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2005-530677 A (CERACOMP CO., LTD.) 13 October 2005 (2005-10-13) paragraphs [0014]-[0084] | 11, 13-25 |
| A | | 1-10, 12 |
| Y | HOFER, Christiane et al. Characterization of Ba(Ti,Zr)O3 ceramics sintered under reducing conditions. Journal of the European Ceramics Society. 2004, vol. 24, issue 6, pp.1473-1477 pp. 2-5 | 11, 13-25 |
| Y | JP 2022-139322 A (CANON KABUSHIKI KAISHA) 26 September 2022 (2022-09-26) paragraphs [0026]-[0211] | 15-25 |

☐ Further documents are listed in the continuation of Box C.      ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **17 June 2024** | **02 July 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**
Information on patent family members

International application No.

**PCT/JP2024/014677**

| Patent document cited in search report | | | Publication date (day/month/year) | Patent family member(s) | | | Publication date (day/month/year) |
|---|---|---|---|---|---|---|---|
| JP | 2005-530677 | A | 13 October 2005 | US | 2005/0150446 | A1 | |
| | | | | paragraphs [0016]-[0101] | | | |
| | | | | EP | 2505694 | A2 | |
| | | | | KR | 10-2004-0033252 | A | |
| | | | | CN | 1692184 | A | |
| JP | 2022-139322 | A | 26 September 2022 | US | 2022/0293849 | A1 | |
| | | | | paragraphs [0055]-[0264] | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3507821 B
- JP 2023066551 A
- JP 2024045263 A

**Non-patent literature cited in the description**

- **IWANAMI SHOTEN**. Iwanami Physics and Chemical Dictionary. 20 February 1998